(19)

Europäisches
Patentamt
European
Patent Office
Office européen
des brevets

(11) **EP 4 749 309 A1**

(12) **EUROPEAN PATENT APPLICATION**
published in accordance with Art. 153(4) EPC

(43) Date of publication:
**27.05.2026  Bulletin 2026/22**

(21) Application number: **24860259.1**

(22) Date of filing: **13.08.2024**

(51) International Patent Classification (IPC):
*G01R 31/396* (2019.01)      *G01R 31/385* (2019.01)
*G01R 31/382* (2019.01)      *G01R 31/374* (2019.01)
*G01R 19/165* (2006.01)      *G01R 19/10* (2006.01)
*B60L 58/10* (2019.01)

(52) Cooperative Patent Classification (CPC):
**B60L 58/10; G01R 19/10; G01R 19/165;
G01R 31/374; G01R 31/382; G01R 31/385;
G01R 31/396; Y02E 60/10**

(86) International application number:
**PCT/KR2024/012057**

(87) International publication number:
**WO 2025/048338 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **31.08.2023  KR 20230115871**

(71) Applicant: **LG Energy Solution, Ltd.
Seoul 07335 (KR)**

(72) Inventors:
• **CHOI, Soon-Hyung
  Daejeon 34122 (KR)**
• **YOON, Seo-Young
  Daejeon 34122 (KR)**
• **KIM, Young-Deok
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS AND METHOD FOR DIAGNOSING BATTERY**

(57)    An apparatus for diagnosing a battery according to the present disclosure includes a profile obtaining unit configured to obtain a battery profile representing a correspondence relationship between voltage and capacity of a battery that is charged or discharged at a predetermined target C-rate; a profile correcting unit configured to generate a corrected profile by correcting the battery profile based on an overpotential profile representing overpotential of a criterion battery for each capacity that occurs when the criterion battery is charged or discharged at the target C-rate, and generate an adjusted negative electrode profile adjusted to represent a correspondence relationship between a negative electrode capacity and a negative electrode potential of the battery using the corrected profile; and a control unit configured to diagnose a state of the battery based on a negative electrode end potential value extracted from the adjusted negative electrode profile.

FIG. 1

APPARATUS FOR DIAGNOSING BATTERY — 100
PROFILE OBTAINING UNIT — 110
PROFILE CORRECTING UNIT — 120
CONTROL UNIT — 130
STORAGE UNIT — 140

EP 4 749 309 A1

## Description

### TECHNICAL FIELD

This application is based on and claims priority from Korean Patent Application No. 10-2023-0115871, filed on August 31, 2023, with the Korean Intellectual Property Office, the disclosure of which is incorporated herein in its entirety by reference.

The present disclosure relates to an apparatus and method for diagnosing a battery, and more particularly, to an apparatus and method for diagnosing a state of a battery capable of repeated charging and discharging.

### BACKGROUND ART

Recently, the demand for portable electronic products such as notebook computers, digital cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to batteries using nickel and thus have relatively long lifespan, very low self-discharging rate and high energy density.

While much research is being conducted on technologies for increasing the capacity and density of these batteries, technologies for increasing the lifespan and improving safety of batteries are also important. In particular, in order to improve battery safety, technologies for accurately diagnosing the current state of the battery are required.

Conventionally, the state of the battery is diagnosed by analyzing the battery profile, which represents the correspondence relationship between capacity and voltage of the battery. For example, during the battery charging process, capacity and voltage of the corresponding battery are measured, and the battery state is diagnosed through analysis of the battery profile, which represents the correspondence relationship between the measured capacity and voltage. As another example, the state of the battery may be diagnosed based on the capacity and voltage measured during the battery discharge process. Therefore, in order to accurately diagnose the current state of the battery, a battery profile that accurately reflects the current state of the battery is required.

However, existing technologies have the problem that battery diagnosis requires a lot of time and cost because they perform low-rate charging and discharging for batteries at a low current of 0.05 C (C-rate) to obtain an accurate battery profile, and thus a large number of batteries cannot be diagnosed accurately and quickly.

On the other hand, when charging and discharging the battery at a high-rate current of 0.3 C or more to shorten the battery diagnosis time, there is a problem in that the acquired battery profile includes overpotential, and due to the influence of this overpotential, the battery profile cannot accurately reflect the current state of the battery.

When using a battery profile that includes overpotential, the battery state cannot be accurately diagnosed, so low-rate charge/discharge, which requires a lot of time and cost when diagnosing the battery state, is being used.

### DISCLOSURE

#### Technical Problem

The present disclosure is designed to solve the problems of the related art, and therefore the present disclosure is directed to providing an apparatus and method for diagnosing a battery, which may diagnose a state of a battery by considering overvoltage of the battery that occurs during charging and discharging using a high-rate current.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

#### Technical Solution

An apparatus for diagnosing a battery according to one aspect of the present disclosure comprises a profile obtaining unit configured to obtain a battery profile representing a correspondence relationship between voltage and capacity of a battery to be diagnosed that is charged or discharged at a predetermined target C-rate; a profile correcting unit configured to generate a corrected profile by correcting the battery profile based on an overpotential profile representing overpotential of a criterion battery for each capacity that occurs when the criterion battery is charged or discharged at the target C-rate, and generate an adjusted negative electrode profile adjusted to represent a correspondence relationship between a negative electrode capacity and a negative electrode potential of the battery to be diagnosed using the corrected profile; and a control unit configured to extract a negative electrode end potential value from the adjusted negative electrode profile as a diagnosis factor for the battery to be diagnosed, and diagnose a state of the battery to be diagnosed based on the extracted diagnosis factor.

In an embodiment, the overpotential profile may be a profile representing a voltage difference for each capacity between a first battery profile of the criterion battery obtained when the criterion battery is charged or discharged at a criterion C-rate and a second battery profile of the criterion battery obtained when the criterion battery is charged or discharged at the target C-rate.

In an embodiment, the profile correcting unit may be configured to generate the corrected profile by calculating a voltage difference for each capacity between the battery profile and the overpotential profile.

In an embodiment, the apparatus for diagnosing a battery may further comprise a storage unit that stores the overpotential profile and other overpotential profiles showing overpotential of the criterion battery for each capacity that occurs when the criterion battery is charged or discharged at a C-rate other than the target C-rate, and the profile correcting unit may be configured to select the overpotential profile corresponding to the target C-rate among overpotential profiles stored in the storage unit and generate the corrected profile using the selected overpotential profile.

In an embodiment, the profile correcting unit may be configured to generate a comparison full-cell profile corresponding to the corrected profile by adjusting and mutually synthesizing a predetermined criterion positive electrode profile and a predetermined criterion negative electrode profile, and provide the criterion negative electrode profile adjusted to generate the comparison full-cell profile as the adjusted negative electrode profile.

In an embodiment, the control unit may be configured to diagnose the battery to be diagnosed as in an abnormal state when the negative electrode end potential value does not correspond to a predetermined threshold range.

In an embodiment, the control unit may be configured to further extract one or more of a negative electrode start potential value, a negative electrode change rate, and a negative electrode loading amount from the adjusted negative electrode profile as a diagnosis factor, and diagnose the state of the battery to be diagnosed based on the extracted diagnosis factors.

In an embodiment, the control unit may be configured to diagnose the battery to be diagnosed as in a normal state when values of diagnosis factors of a predetermined number or more among the extracted diagnosis factors fall within threshold ranges respectively corresponding thereto.

A battery pack according to another aspect of the present disclosure may comprise the apparatus for diagnosing a battery according to any one of the above embodiments.

A battery manufacturing system according to still another aspect of the present disclosure may comprise the apparatus for diagnosing a battery according to any one of the above embodiments.

A vehicle according to still another aspect of the present disclosure may comprise the apparatus for diagnosing a battery according to any one of the above embodiments.

A method for diagnosing a battery according to another aspect of the present disclosure may comprise a profile obtaining step of obtaining a battery profile representing a correspondence relationship between voltage and capacity of a battery to be diagnosed that is charged or discharged at a predetermined target C-rate; a corrected profile generating step of generating a corrected profile by correcting the battery profile based on an overpotential profile representing overpotential of a criterion battery for each capacity that occurs when the criterion battery is charged or discharged at the target C-rate; a profile adjusting step of generating an adjusted negative electrode profile adjusted to represent a correspondence relationship between a negative electrode capacity and a negative electrode potential of the battery to be diagnosed using the corrected profile; a diagnosis factor extracting step of extracting a negative electrode end potential value from the adjusted negative electrode profile as a diagnosis factor for the battery to be diagnosed; and a state diagnosing step of diagnosing a state of the battery to be diagnosed based on the negative electrode end potential value.

## Advantageous Effects

The apparatus and method for diagnosing a battery according to the present disclosure generates a corrected profile by removing overpotential from a battery profile that represents a correspondence relationship between the capacity and voltage of the battery, and diagnoses the state of the battery based on this corrected profile, so it has the advantage in that the battery to be diagnosed is not forced to be charged or discharged using a low C-rate current.

That is, according to the present disclosure, even when charging or discharging a battery with a current of a C-rate higher than the generally used C-rate, the state of the corresponding battery may be accurately diagnosed. As a result, the time and cost required to diagnose the state of the battery may be reduced, and a large number of batteries may be diagnosed accurately and quickly.

In addition, the apparatus and method for diagnosing a battery according to the present disclosure has the advantage of further shortening the diagnosis time by performing the diagnosis through a simplified process of extracting diagnosis factors that serve as criteria for diagnosis for a plurality of batteries, determining a threshold range of values that the diagnosis factors of a normal battery may have based on the extracted diagnosis factors, and comparing the diagnosis factor values of the battery to be diagnosed with the threshold range.

In addition, the apparatus and method for diagnosing a battery according to the present disclosure may specifically diagnose the state of the battery related to the negative electrode by extracting a negative electrode-related diagnosis factor from an adjusted negative electrode profile representing the negative electrode state of the battery and diagnosing the corresponding battery based on the extracted diagnosis factor.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide understanding of the technical features of the present disclosure, and thus, the present disclosure is not construed as being limited to the drawing.

FIG. 1 is a diagram schematically showing an apparatus for diagnosing a battery according to an embodiment of the present disclosure.
FIG. 2 is a diagram schematically showing an overpotential profile according to an embodiment of the present disclosure.
FIG. 3 is a diagram schematically showing a battery profile according to an embodiment of the present disclosure.
FIG. 4 is a diagram schematically showing a corrected profile according to an embodiment of the present disclosure.
FIG. 5 is a diagram schematically showing the distribution of diagnosis factors according to an embodiment of the present disclosure.
FIGS. 6 to 10 are drawings illustrating distributions of diagnosis factor values extracted from a plurality of batteries.
FIGS. 11 to 18 are drawings illustrating a process for adjusting a criterion positive electrode profile and a criterion negative electrode profile according to an embodiment of the present disclosure.
FIG. 19 is a diagram schematically showing an exemplary configuration of a battery pack according to another embodiment of the present disclosure.
FIG. 20 is a diagram showing a battery manufacturing process of a battery manufacturing system according to still another embodiment of the present disclosure.
FIG. 21 is a diagram schematically showing an exemplary configuration of a vehicle according to still another embodiment of the present disclosure.
FIG. 22 is a diagram schematically showing a method for diagnosing a battery according to still another embodiment of the present disclosure.

BEST MODE

Hereinafter, in order to clearly present a solution corresponding to the technical challenge of the present disclosure, embodiments according to the present disclosure are described in detail with reference to the attached drawings.

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or techniques renders the key subject matter of the present disclosure unclear, the detailed description thereof is omitted herein.

Additionally, the terms used in this specification including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

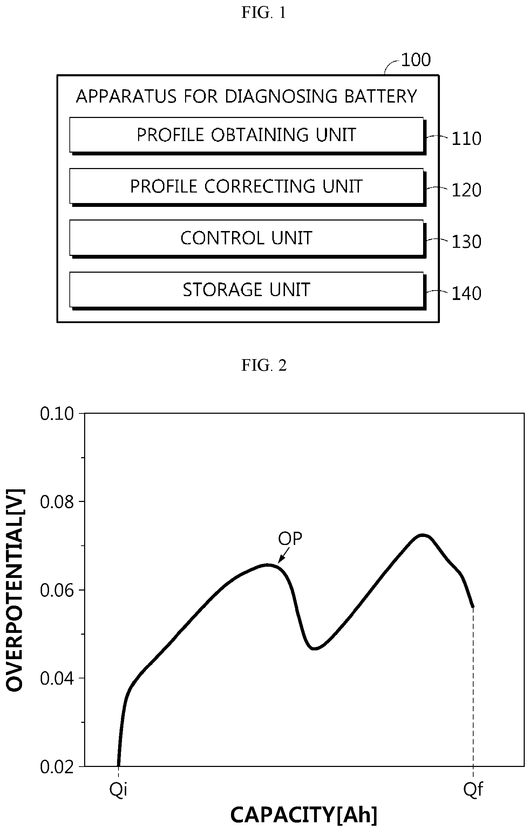

FIG. 1 is a diagram schematically showing an apparatus 100 for diagnosing a battery according to an embodiment of the present disclosure.

Referring to FIG. 1, the apparatus 100 for diagnosing a battery may include a profile obtaining unit 110, a profile correcting unit 120, and a control unit 130.

The profile obtaining unit 110 is configured to obtain a battery profile representing a correspondence relationship between voltage and capacity of a battery to be diagnosed when charging or discharging at a predetermined target C-rate. For example, the profile obtaining unit 110 may be configured to obtain a plurality of battery profiles BP indicating the correspondence relationship between the voltage and capacity of each of a plurality of batteries.

Here, the battery may refer to an independent cell that has a negative terminal and a positive terminal and is physically separable. As an example, a lithium-ion battery or a lithium polymer battery may be considered as a battery. Additionally, the battery may mean a battery bank, a battery module or a battery pack in which a plurality of cells are connected in series and/or parallel. Below, for convenience of explanation, the battery is explained as meaning one independent cell.

Specifically, the battery profile BP is a profile that represents the correspondence relationship between voltage (V) and capacity (Q) of the corresponding battery until the SOC (State of Charge) of the battery is charged from 0% to 100%. Alternatively, the battery profile BP may represent the correspondence relationship between voltage (V) and capacity (Q) until the SOC of the battery is discharged from 100% to 0%. For example, the battery profile BP may be generated based on the voltage and electric capacity of the corresponding battery measured while the battery is being charged or discharged at a predetermined C-rate (Current rate). Here, the C-rate of the charging current or discharging current may be kept constant while the battery profile BP is generated. That is, when the C-rate for charging and discharging is set, the set C-rate may remain constant until charging and discharging ends.

For reference, 1 C (C-rate) may refer to the current that may fully charge a completely discharged battery by charging it for 1 hour, or the current that may fully discharge a fully charged battery by discharging it for 1 hour. As the C-rate increases, the corresponding current increases, and as the C-rate decreases, the corresponding current decreases. For example, 2 C may refer to the amount of current that may fully charge a completely discharged battery by charging it for 0.5 hours, or the amount of current that may fully discharge a fully charged battery by discharging it for 0.5 hours.

For example, the profile obtaining unit 110 may directly receive the battery profile BP from an external device. That is, the profile obtaining unit 110 may obtain the battery profile BP by receiving the battery profile BP from the corresponding external device by being connected to the external device by wire and/or wirelessly.

As another example, the profile obtaining unit 110 may receive battery information about the voltage (V) and capacity (Q) of the battery. Additionally, the profile obtaining unit 110 may generate a battery profile BP based on the received battery information. That is, the profile obtaining unit 110 may obtain the battery profile BP by directly generating the battery profile BP based on battery information.

The profile obtaining unit 110 may be connected to enable communication with the profile correcting unit 120. For example, the profile obtaining unit 110 may be connected to the control unit 130 by wire and/or wirelessly. The profile obtaining unit 110 may transmit the obtained battery profile BP to the profile correcting unit 120.

The profile correcting unit 120 may be configured to generate a plurality of corrected profiles CP by correcting the plurality of battery profiles BP based on the preset overpotential profile OP.

For example, the profile correcting unit 120 may be configured to generate a corrected profile by correcting the battery profile based on an overpotential profile representing overpotential of the criterion battery for each capacity that occurs when the criterion battery is charged or discharged at the target C-rate, and to generate an adjusted negative electrode profile adjusted to represent a correspondence relationship between the negative electrode capacity and the negative electrode potential of the battery to be diagnosed using the corrected profile.

Here, the overpotential profile OP is a profile representing a correspondence relationship between the capacity and overpotential of a battery charged or discharged with a current of a predetermined C-rate. For example, the overpotential profile OP is a profile representing a voltage difference for each capacity between a first battery profile of the criterion battery obtained when the predetermined criterion battery is charged or discharged with a criterion C-rate and a second battery profile of the criterion battery obtained when the criterion battery is charged or discharged with the target C-rate.

In general, when a battery is charged or discharged with a current having a C-rate higher than the criterion C-rate, overpotential may be included in the measured voltage of the battery. Therefore, the overpotential profile OP may be obtained by calculating the voltage difference for each capacity between the first battery profile BP1 of the criterion battery that is charged or discharged with a current having a criterion C-rate and the second battery profile BP2 of the criterion battery that is charged or discharged with a current having a C-rate that is the same as the target C-rate of the charging current or discharging current of the battery to be diagnosed.

For example, it is assumed that the criterion C-rate is 0.05 C and the target C-rate is 0.3 C. When the criterion battery is charged (or discharged) at 0.05 C, a first battery profile BP1 may be obtained. When the criterion battery is charged (or discharged) at 0.3 C, a second battery profile BP2 may be obtained. The difference between the voltage of the first battery profile BP1 corresponding to the specific capacity and the voltage of the second battery profile BP2 may be calculated as the overpotential at the specific capacity. That is, when the voltage difference (overpotential) for each capacity between the first battery profile BP1 and the second battery profile BP2 is calculated, an overpotential profile OP representing the correspondence relationship between the capacity and the overpotential may be generated.

FIG. 2 is a diagram schematically showing an overpotential profile OP according to an embodiment of the present disclosure.

Specifically, FIG. 2 is a diagram showing the overpotential profile OP generated in the process of discharging the criterion battery from start capacity (Qi) to end capacity (Qf). The first battery profile BP1 may be generated as the criterion battery is discharged from start capacity (Qi) to end capacity (Qf) at the criterion C-rate. In addition, the second battery profile BP2 may be generated as the criterion battery is discharged from start capacity (Qi) to end capacity (Qf) at the target C-rate. The overpotential profile OP may be generated by calculating the voltage difference for each discharge capacity between the first battery profile BP1 and the second battery profile BP2 from start capacity (Qi) to end capacity (Qf).

The profile correcting unit 120 may be configured to generate a plurality of corrected profiles CP by calculating the voltage difference for each capacity between each of the plurality of battery profiles BP and the overpotential profile OP.

Specifically, the profile correcting unit 120 may remove the overpotential profile OP from the battery profile BP. For example, the profile correcting unit 120 may calculate the difference between the voltage of the battery profile BP and the overpotential of the overpotential profile OP for the same capacity to generate a corrected profile CP. In other words, the corrected profile CP is a profile in which the overpotential profile OP is removed from the battery profile BP.

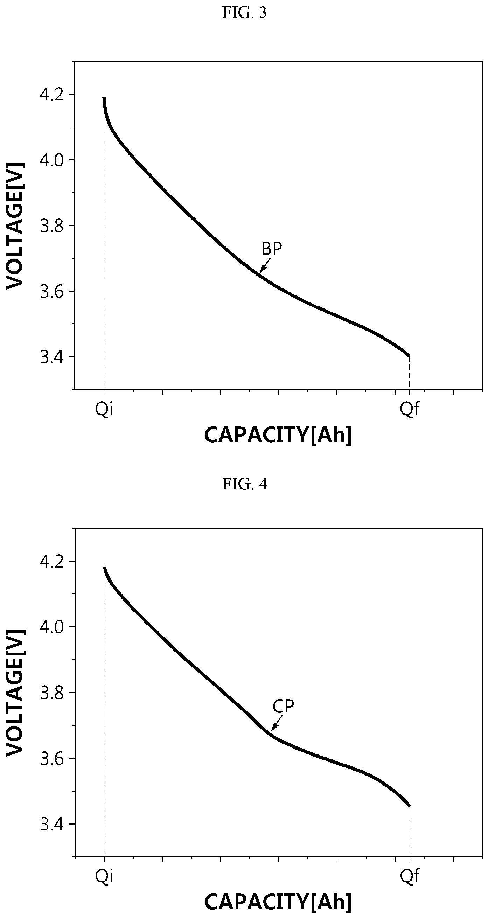

FIG. 3 is a diagram schematically showing a battery profile BP according to an embodiment of the present disclosure. FIG. 4 is a diagram schematically showing a corrected profile CP according to an embodiment of the present disclosure.

Specifically, the battery profile BP in FIG. 3 is a profile obtained when the battery to be diagnosed is discharged at the target C-rate from start capacity (Qi) to end capacity (Qf).

Referring to FIGS. 2 to 4, the profile correcting unit 120 may generate the corrected profile CP of FIG. 4 by removing the overpotential profile OP of FIG. 2 from the battery profile BP of FIG. 3. Here, the target C-rate corresponding to the battery profile BP in FIG. 3 and the target C-rate corresponding to the overpotential profile OP in FIG. 2 are the same. In other words, the corrected profile CP may be generated based on the battery profile BP and the overpotential profile OP for the same target C-rate.

The profile correcting unit 120 may be configured to generate an adjusted positive electrode profile and an adjusted negative electrode profile corresponding to each battery by adjusting a preset criterion positive electrode profile and a preset criterion negative electrode profile to correspond to each of the plurality of corrected profiles CP.

The criterion positive electrode profile is a profile representing a correspondence relationship between the capacity and voltage of the preset criterion positive electrode cell to correspond to the positive electrode of the battery. For example, the criterion positive electrode cell may be a positive electrode coin half-cell or a positive electrode of a three-electrode cell.

Additionally, the criterion negative electrode profile is a profile representing a correspondence relationship between the capacity and voltage of the preset criterion negative electrode cell to correspond to the negative electrode of the battery. For example, the criterion negative electrode cell may be a negative electrode coin half-cell or a negative electrode of a three-electrode cell.

For example, the profile correcting unit 120 may adjust the criterion positive electrode profile and the criterion negative electrode profile to correspond to the corrected profile CP. That is, the profile correcting unit 120 may adjust the criterion positive electrode profile and the criterion negative electrode profile to generate an adjusted positive electrode profile and an adjusted negative electrode profile.

Then, the profile correcting unit 120 may generate a comparison full-cell profile from the adjusted positive electrode profile and the adjusted negative electrode profile. The profile correcting unit 120 may repeatedly adjust the criterion positive electrode profile and the criterion negative electrode profile until the comparison full-cell profile corresponds to the corrected profile CP.

For example, the profile correcting unit 120 may generate a plurality of comparison full-cell profile by shifting the criterion positive electrode profile and the criterion negative electrode profile or scaling the capacities thereof, and specify a comparison full-cell profile with the minimum error with the corrected profile CP among the plurality of comparison full-cell profiles. Then, an adjusted positive electrode profile and an adjusted negative electrode profile corresponding to the specified comparison full-cell profile may be determined.

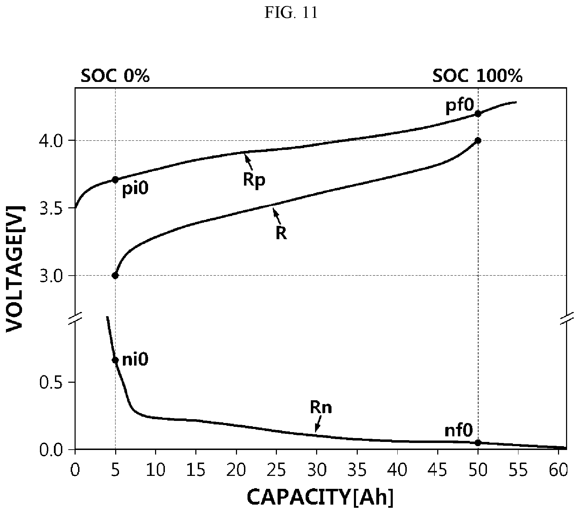

A more specific embodiment in which the profile correcting unit 120 determines the adjusted positive electrode profile and the adjusted negative electrode profile of the battery to be diagnosed by adjusting the criterion positive electrode profile and the criterion negative electrode profile to correspond to the corrected profile CP will be described later with reference to FIGS. 11 to 18.

The control unit 130 may be configured to extract a diagnosis factor, which is a criterion for diagnosis, from at least one of the adjusted positive electrode profile and the adjusted negative electrode profile of the battery to be diagnosed. For example, the control unit 130 may extract one or more of the negative electrode start potential value, the negative electrode end potential value, the negative electrode change rate, the positive electrode loading amount, and the NP ratio from the adjusted negative electrode profile as diagnosis factors, and diagnose the state of the battery to be diagnosed based on the extracted diagnosis factors.

As described later, the control unit 130 may extract a diagnosis factor related to the positive electrode from the adjusted positive electrode profile. Additionally, the control unit 130 may extract a diagnosis factor related to the negative electrode from the adjusted negative electrode profile. Additionally, the control unit 130 may extract a diagnosis factor related to both positive and negative electrodes by considering both the diagnosis factor related to the positive electrode and the diagnosis factor related to the negative electrode.

For example, the control unit 130 may extract a plurality of diagnosis factors respectively corresponding to the plurality of batteries based on the adjusted positive electrode profile and/or the adjusted negative electrode profile corresponding to each of the plurality of batteries. In this case, the control unit 130 may extract the same type of diagnosis factor for each battery.

The control unit 130 may be configured to diagnose the state of the plurality of batteries based on the extracted plurality of diagnosis factors.

Specifically, since a plurality of diagnosis factors may be represented by values of the same type, the control unit 130 may generate a distribution diagram representing the distribution of diagnosis factor values of the plurality of diagnosis factors. In addition, the control unit 130 may determine a threshold range of values that the diagnosis factor of the normal battery may have based on the generated distribution diagram.

As a result, the control unit 130 may further shorten the diagnosis time by performing the diagnosis through a simplified process of comparing the diagnosis factor value of the battery to be diagnosed with the threshold range.

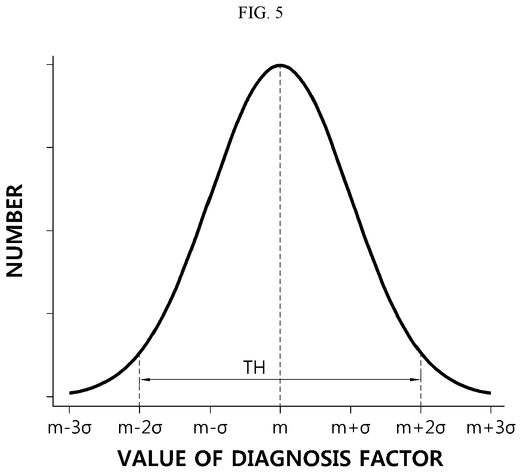

FIG. 5 is a diagram schematically showing the distribution of diagnosis factors according to an embodiment of the present disclosure. Specifically, FIG. 5 is a diagram illustrating an embodiment in which the distribution of a plurality of diagnosis factors follows a normal distribution.

As illustrated in FIG. 5, the control unit 130 may determine a threshold range (TH) of values that a diagnosis factor of a normal battery may have by using a statistical analysis method, compare the diagnosis factor value of the battery to be diagnosed with the threshold range (TH), and diagnose the state of the battery to be diagnosed as a normal state or an abnormal state based on the comparison result.

For example, the control unit 130 may be configured to select a diagnosis factor out of the threshold range (TH) among a plurality of diagnosis factors by considering a distribution of the plurality of diagnosis factors, and to diagnose the state of the battery corresponding to the selected diagnosis factor as an abnormal state. Conversely, the control unit 130 may be configured to select a diagnosis factor included in the threshold range (TH) among a plurality of diagnosis factors, and to diagnose the state of the battery corresponding to the selected diagnosis factor as a normal state.

For example, if the average value of the diagnosis factors is m and the standard deviation is $\sigma$, the threshold range TH may be determined as a range of m - $2\sigma$ or more and m + $2\sigma$ or less. The control unit 130 may classify the plurality of diagnosis factors into diagnosis factors that belong to the threshold range TH and diagnosis factors that do not belong to the threshold range TH.

Then, the control unit 130 may diagnose the state of the battery corresponding to the diagnosis factor belonging to the threshold range TH as a normal state, and diagnose the state of the battery corresponding to the diagnosis factor not belonging to the threshold range TH as an abnormal state.

In the above, for convenience of explanation, an embodiment of the threshold range TH set based on $2\sigma$ has been described, but it should be noted that the threshold range TH is not limited to the range of m - $2\sigma$ to m + $2\sigma$.

As described above, after the threshold range (TH) of values that the diagnosis factor of a normal battery may have is determined, when diagnosis is performed on new batteries, the control unit 130 may quickly diagnose the state of the new batteries through a simplified process of comparing the diagnosis factor values of the new batteries with the threshold range (TH).

The apparatus 100 for diagnosing a battery according to the present disclosure diagnoses the state of the battery based on the corrected profile CP in which the overpotential is removed from the battery profile BP, so there is an advantage in that charging and discharging with a current of the criterion C-rate is not forced to diagnose the state of the battery. In other words, since the state of the corresponding battery may be diagnosed even if the battery is charged and discharged with a current of a C-rate other than the criterion C-rate, namely a current of a higher C-rate than the criterion C-rate, the state of the battery may be diagnosed quickly without restrictions on charging and discharging conditions.

In addition, the apparatus 100 for diagnosing a battery has an advantage of quickly distinguishing a normal battery and an abnormal battery by relatively comparing the states of the plurality of batteries based on the distribution of the plurality of diagnosis factors.

Meanwhile, the control unit 130 included in the apparatus 100 for diagnosing a battery may include a general-purpose processor or an ASIC (Application-Specific Integrated Circuit) known in the art to execute various control logics performed in the present disclosure, and may further optionally include a processor, an application-specific integrated circuit (ASIC), other chipset, a logic circuit, a register, a memory, a communication modem, etc. Also, when the control logic is implemented as software, the control unit 130 may be implemented as a set of program modules. At this time, the program module may be stored in the memory and executed by the control unit 130. The memory may be included in the control unit 130 or may be located outside the control unit 130 and connected to the control unit 130 by wire and/or wirelessly.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that may record, erase, update and read data. As an example, the information storage means may optionally include RAM, ROM, EEPROM, flash memory, registers, and the like. In addition, the storage unit 140 may store program codes in which processes executable by the control unit 130 are defined.

For example, the storage unit 140 may store the plurality of battery profiles BP, the overpotential profile OP, the plurality of corrected profiles CP, the criterion positive electrode profile, the criterion negative electrode profile, the adjusted positive electrode profile, the adjusted negative electrode profile, and the plurality of diagnosis factors.

In an embodiment, the storage unit 140 may store overpotential profiles that represent overpotential of the criterion battery for each capacity that occurs when the criterion battery is charged or discharged at a C-rate different from the target C-rate, together with the overpotential profile OP.

That is, the storage unit 140 may store a plurality of overpotential profiles OP, respectively corresponding to a variety of C-rates that may be applied to charging or discharging of the battery to be diagnosed. For example, the plurality of overpotential profiles OP may include a first overpotential profile OP1 that may be used for correction of a first battery profile acquired while the battery to be diagnosed is charged or discharged with a current of a first C-rate, and a second overpotential profile OP2 that may be used for correction of a second battery profile acquired while the battery to be diagnosed is charged or discharged with a current of a second C-rate.

Additionally, an overpotential profile OP for C-rate that is not experimentally obtained may be obtained and stored through interpolation or extrapolation between similar overpotential profiles OP. For example, if the overpotential profile OP corresponding to 1 C and the overpotential profile OP corresponding to 1.2 C are stored in advance, an overpotential profile OP corresponding to 1.1 C may be additionally obtained based on the difference between the two overpotential profiles OP.

In this case, the profile correcting unit 120 may be configured to select an overpotential profile OP corresponding to the target C-rate among the plurality of overpotential profiles OP stored in advance and generate the corrected profile using the selected overpotential profile.

Here, the target C-rate is a C-rate set of the charging current or discharging current of the battery to be diagnosed. For example, if a plurality of battery profiles BP is obtained in the process of charging the plurality of batteries at 0.3 C, the target C-rate is 0.3 C. The profile correcting unit 120 may select the overpotential profile OP corresponding to 0.3 C among the plurality of overpotential profiles OP.

The profile correcting unit 120 may be configured to generate a plurality of corrected profiles CP using the selected overpotential profile OP.

For example, the profile correcting unit 120 may generate a plurality of corrected profiles CP by calculating the difference between each of the plurality of battery profiles BP and the selected overpotential profile OP. That is, the profile correcting unit 120 may obtain a plurality of corrected profiles CP from which overpotential is commonly removed.

Because overpotential corresponds to noise, the battery profile BP having overpotential may not accurately reflect the current state of the battery. Therefore, the apparatus for diagnosing a battery according to an embodiment of the present disclosure may remove the overpotential included in the battery profile BP using the overpotential profile OP corresponding to the target C-rate. In other words, the apparatus for diagnosing a battery has an advantage of more accurately diagnosing the state of the battery based on the corrected profile CP from which overpotential is removed.

In an embodiment, the storage unit 140 may store a plurality of overpotential profiles OPa (hereinafter, charge overpotential profiles OPa) corresponding to the C-rate of the charging current and a plurality of overpotential profiles OPb (hereinafter, discharge overpotential profiles OPb) corresponding to the C-rate of the discharging current in advance. That is, the plurality of charge overpotential profiles OPa and the plurality of discharge overpotential profiles OPb may be stored independently.

In general, batteries exhibit a hysteresis effect during charging and discharging, so even if the voltage is the same, the charging capacity and discharging capacity may have different values. Therefore, in order to more accurately diagnose the state of the battery, it is desirable to store the overpotential profiles corresponding to the C-rate of the charging current and the overpotential profiles corresponding to the C-rate of the discharging current separately.

Meanwhile, the control unit 130 may determine the charging and discharging process (charging process or discharging process) corresponding to the battery profile BP. For example, the control unit 130 may determine the charging and discharging process of the battery profile BP by comparing the sizes of start capacity and end capacity. Additionally, the control unit 130 may select the corresponding overpotential profile OP based on the determined charging and discharging process and the target C-rate.

The apparatus 100 for diagnosing a battery according to an embodiment of the present disclosure may more accurately diagnose the state of a plurality of batteries by selecting an overpotential profile OP in consideration of the target C-rate and the charging and discharging process.

Meanwhile, the profile correcting unit 120 may generate a comparison full-cell profile corresponding to the corrected profile by adjusting and mutually synthesizing a predetermined criterion positive electrode profile and a predetermined criterion negative electrode profile, and provide the adjusted criterion negative electrode profile as the adjusted negative electrode profile to the control unit 130 to generate the comparison full-cell profile.

Below, diagnosis factors that the control unit 130 may extract from the adjusted positive electrode profile and/or the adjusted negative electrode profile will be described in detail.

The control unit 130 may be configured to extract at least one of a positive electrode-related diagnosis factor based on the adjusted positive electrode profile, a negative electrode-related diagnosis factor based on the adjusted negative electrode profile, and a positive and negative electrode-related diagnosis factor based on both the adjusted positive electrode profile and the adjusted negative electrode profile as a diagnosis factor.

Here, the adjusted positive electrode profile is the result of adjusting the criterion positive electrode profile, and the adjusted negative electrode profile is the result of adjusting the criterion negative electrode profile. As described above, the profile correcting unit 120 may adjust the corresponding criterion positive electrode profile and the corresponding criterion negative electrode profile so that the comparison full-cell profile generated based on the criterion positive electrode profile and the criterion negative electrode profile corresponds to the corrected profile CP.

The positive electrode-related factor may include at least one of a positive electrode start potential, a positive electrode end potential, a positive electrode change rate, and a positive electrode loading amount of the battery based on the adjusted positive electrode profile.

The positive electrode start potential is a start potential of the adjusted positive electrode profile, and the positive electrode end potential is an end potential of the adjusted positive electrode profile. Specifically, the positive electrode start potential is a potential value of the positive electrode participation initiating point pi of the adjusted positive electrode profile. The positive electrode end potential is a potential value of the positive electrode participation finalizing point pf of the adjusted positive electrode profile.

The positive electrode change rate (ps) may mean a change rate [%] of the adjusted positive electrode profile with respect to the criterion positive electrode profile. Specifically, the positive electrode change rate (ps) may be a contraction rate or expansion rate of the adjusted positive electrode profile with respect to the criterion positive electrode profile. For example, if the adjusted positive electrode profile is 10% shrinkage from the criterion positive electrode profile, the positive electrode change rate (ps) is 90%. Conversely, if the adjusted positive electrode profile is 10% extension of the criterion positive electrode profile, the positive electrode change rate (ps) is 110%.

The positive electrode loading amount refers to an amount of positive electrode active material coated on the positive electrode current collector. Since the adjusted positive electrode profile is a profile representing the current state of the positive electrode of the battery, the control unit 130 may calculate the positive electrode loading amount based on the adjusted positive electrode profile.

For example, the control unit 130 may calculate the positive electrode loading amount in consideration of the positive electrode change rate (ps), a preset criterion positive electrode capacity, and a preset criterion area. Here, the criterion positive electrode capacity may mean a capacity of a preset criterion positive electrode cell. Also, the criterion area may mean the area of the preset criterion positive electrode cell. Specifically, the control unit 130 may calculate the positive electrode loading amount using Equation 1 below.

**[Equation 1]**

$$p\_loading = (ps \times Q_{rc}) / A_{pc}$$

Here, p_loading represents the positive electrode loading amount, and ps represents the positive electrode change rate. $Q_{rc}$ represents the criterion positive electrode capacity, and $A_{pc}$ represents the criterion area.

The negative electrode-related diagnosis factor may include at least one of a negative electrode start potential, a negative electrode end potential, a negative electrode change rate (ns), and a negative electrode loading amount of the battery based on the adjusted negative electrode profile.

The negative electrode start potential is a start potential of the adjusted negative electrode profile, and the negative electrode end potential is an end potential of the adjusted negative electrode profile. Specifically, the negative electrode start potential is a potential value of the negative electrode participation initiating point ni of the adjusted negative electrode profile. The negative electrode end potential is a potential value of the negative electrode participation finalizing point nf of the adjusted negative electrode profile.

The negative electrode change rate (ns) may mean the change rate [%] of the adjusted negative electrode profile with respect to the criterion negative electrode profile. Specifically, the negative electrode change rate (ns) may be the contraction rate or expansion rate of the adjusted negative electrode profile with respect to the criterion negative electrode profile. For example, if the adjusted negative electrode profile is 10% shrinkage from the criterion negative electrode profile, the negative electrode change rate (ns) is 90%. Conversely, if the adjusted negative electrode profile is 10% extension of the criterion negative electrode profile, the negative electrode change rate (ns) is 110%.

The negative electrode loading amount refers to the amount of negative electrode active material coated on the negative electrode current collector. Since the corrected negative electrode profile is a profile indicating the current state of the negative electrode of the battery, the control unit 130 may calculate the negative electrode loading amount based on the corrected negative electrode profile. Specifically, the control unit 130 may calculate the negative electrode loading amount in consideration of the negative electrode change rate, a preset criterion negative electrode capacity, and a preset criterion area. Here, the criterion negative electrode capacity may mean the capacity of a preset criterion negative electrode cell. The criterion area may mean the area of a preset criterion negative electrode cell. Specifically, the control unit 130 may calculate the negative electrode loading amount based on the negative electrode change rate, the criterion negative electrode capacity, and the criterion area using Equation 2 below.

**[Equation 2]**

$$n\_loading = (ns \times Q_{ra}) / A_{pa}$$

Here, n_loading represents the negative electrode loading amount, and ns represents the negative electrode change rate. $Q_{ra}$ represents the criterion negative electrode capacity, and $A_{pa}$ represents the criterion area.

The positive and negative electrode-related factors may include an NP ratio that may be calculated based on the positive electrode loading amount and the negative electrode loading amount.

Specifically, the NP ratio refers to the rate of positive electrode capacity to negative electrode capacity. For example, the control unit 130 may calculate the NP ratio using Equation 3 below.

**[Equation 3]**

$$np\ ratio = n\text{-}loading / p\text{-}loading$$

Here, np ratio is the NP ratio, p-loading is the positive electrode loading amount according to Equation 1, and n-loading is the negative electrode loading amount according to Equation 2.

The apparatus 100 for diagnosing a battery may extract at least one of the positive electrode start potential, the positive electrode end potential, the positive electrode change rate, the positive electrode loading amount, the negative electrode start potential, the negative electrode end potential, the negative electrode change rate, and the NP ratio as a diagnosis factor. In addition, the apparatus 100 for diagnosing a battery may diagnose the state of the plurality of batteries as normal state or abnormal state based on the distribution for each extracted diagnosis factor.

For example, the apparatus 100 for diagnosing a battery according to an embodiment of the present disclosure may extract a negative electrode-related diagnosis factor or a positive and negative electrode-related diagnosis factor from the adjusted negative electrode profile described above to diagnose a state of a negative electrode, such as manufacturing quality or capacity loss of the negative electrode among the electrodes of the battery, and perform a diagnosis based on the extracted diagnosis factor.

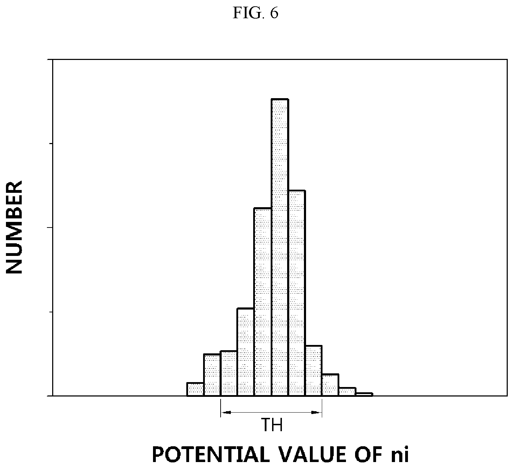

FIGS. 6 to 10 are drawings illustrating distributions of diagnosis factor values extracted from a plurality of batteries.

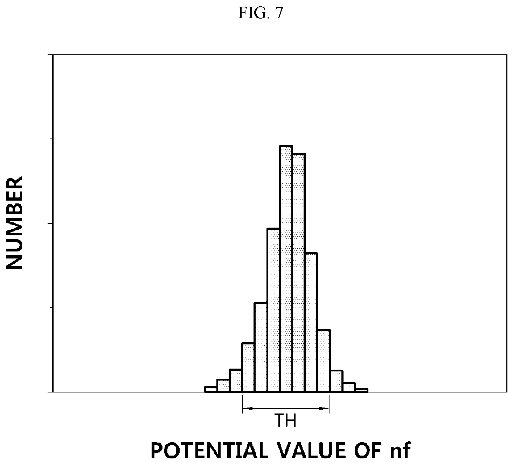

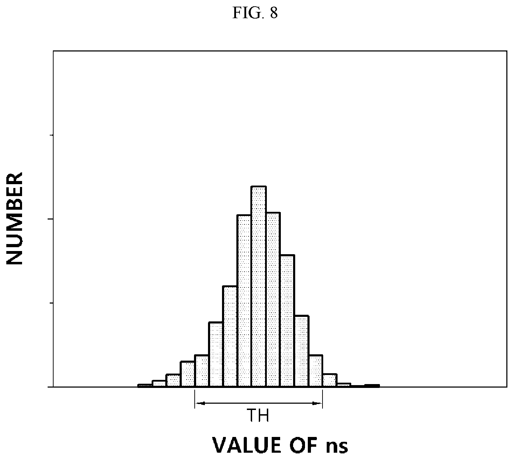

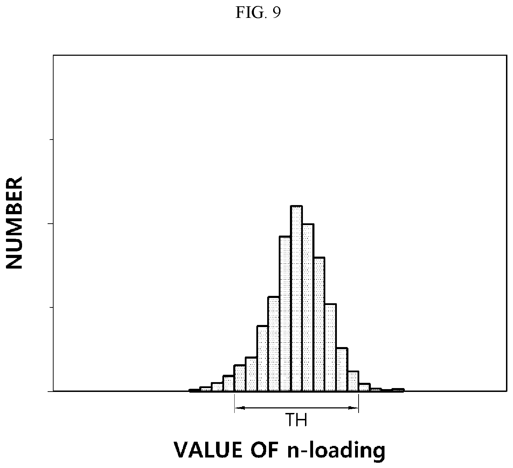

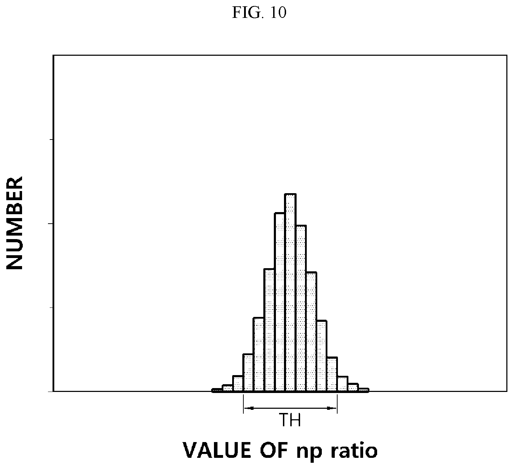

Specifically, FIG. 6 is a graph showing the distribution of negative electrode start potential values extracted from a plurality of batteries. FIG. 7 is a graph showing the distribution of negative electrode end potential values extracted from a plurality of batteries. FIG. 8 is a graph showing the distribution of negative electrode change rate values extracted from a plurality of batteries. FIG. 9 is a graph showing the distribution of negative electrode loading amount values extracted from a plurality of batteries. FIG. 10 is a graph showing the distribution of NP ratio values extracted from a plurality of batteries. As described above, when the mean value is m and the standard deviation is $\sigma$ in FIGS. 6 to 10, it is assumed that the threshold range (TH) of the normal diagnosis factor value is determined as $m \pm 2\sigma$.

The control unit 130 may diagnose the state of the plurality of batteries based on the distribution of the extracted diagnosis factors when specific types of diagnosis factors are extracted from the plurality of batteries.

Specifically, the control unit 130 may extract diagnosis factors related to items of interest among predetermined battery diagnosis items from the batteries, and diagnose the state of the batteries based on the extracted diagnosis factors. The items of interest are selected by a user or a preset program, and the control unit 130 may be configured to obtain information about the selected items of interest.

For example, if the item of interest is related to the state of the negative electrode, the control unit 130 may extract negative electrode start potential values from a plurality of adjusted negative electrode profiles for the plurality of batteries, respectively. Then, the control unit 130 may select a negative electrode start potential that is out of the threshold range (TH) among the extracted negative electrode start potential values. That is, as illustrated in FIG. 6, the control unit 130 may select a negative electrode start potential that exceeds the upper limit ($m + 2\sigma$) of the threshold range (TH) or is less than the lower limit ($m - 2\sigma$) of the threshold range (TH). Then, the control unit 130 may diagnose the state of the battery corresponding to the selected negative electrode start potential as an abnormal state. On the other hand, the control unit 130 may diagnose the state of the remaining batteries as a normal state.

As such, the apparatus 100 for diagnosing a battery according to an embodiment of the present disclosure may extract diagnosis factors related to diagnosis items of interest and diagnose the state of the battery based on the extracted diagnosis factors. Therefore, the apparatus 100 for diagnosing a battery may accurately diagnose the state of the battery based on the corrected profile CP with overpotential removed, and has the advantage of being able to diagnose the state of the battery for each detailed diagnosis item.

Below, an embodiment in which the profile correcting unit 120 adjusts the criterion positive electrode profile and the criterion negative electrode profile will be described in detail.

The profile correcting unit 120 may be configured to generate a comparison full-cell profile based on the criterion positive electrode profile and the criterion negative electrode profile.

Specifically, the comparison full-cell profile may be generated according to the voltage difference for each capacity for the criterion positive electrode profile and the criterion negative electrode profile. For example, it is assumed that the voltage of the criterion positive electrode profile corresponding to a certain capacity x is Vp, and the voltage of the criterion negative electrode profile is Vn. The voltage of the comparison full-cell profile corresponding to the capacity x may be calculated as "Vp - Vn". The profile correcting unit 120 may generate a comparison full-cell profile by calculating the voltage difference between the criterion positive electrode profile and the criterion negative electrode profile for the entire capacity.

The profile correcting unit 120 may be configured to generate an adjusted positive electrode profile and an adjusted negative electrode profile by adjusting the criterion positive electrode profile and the criterion negative electrode profile until the generated comparison full-cell profile corresponds to the corrected profile CP.

Specifically, the profile correcting unit 120 may calculate an error between the comparison full-cell profile and the corrected profile CP. Additionally, the profile correcting unit 120 may adjust the criterion positive electrode profile and the criterion negative electrode profile until the error between the comparison full-cell profile and the corrected profile CP is minimized. If the comparison full-cell profile that minimizes the error with the corrected profile CP is determined, the adjusted positive electrode profile and the adjusted negative electrode profile, which are the basis of the determined comparison full-cell profile, may be estimated as the positive electrode profile and the negative electrode profile that represent the current state of the battery.

With current technology, there is a problem that it is not possible to directly obtain the positive electrode profile and the negative electrode profile indicating the current state of the battery without directly disassembling the battery. Therefore, in the present disclosure, the adjusted positive electrode profile and the adjusted negative electrode profile, which are the basis of the comparison full-cell profile determined through the adjustment process, are used as the positive electrode profile and the negative electrode profile that reflect the current state of the battery.

Hereinafter, with reference to FIGS. 11 to 18, an embodiment in which the profile correcting unit 120 adjusts the criterion positive electrode profile and the criterion negative electrode profile will be described in more detail.

FIGS. 11 to 18 are diagrams illustrating a process of adjusting a criterion positive electrode profile and a criterion negative electrode profile according to an embodiment of the present disclosure. Below, for convenience of explanation, the corrected profile CP according to an embodiment of the present disclosure is described as a measurement full-cell profile M.

FIG. 11 is a graph referenced to for explaining an example of the criterion positive electrode profile Rp and the criterion negative electrode profile Rn, respectively. In the graph of FIG. 11, the horizontal axis (X-axis) represents capacity (Ah) and the vertical axis (Y-axis) represents voltage (V).

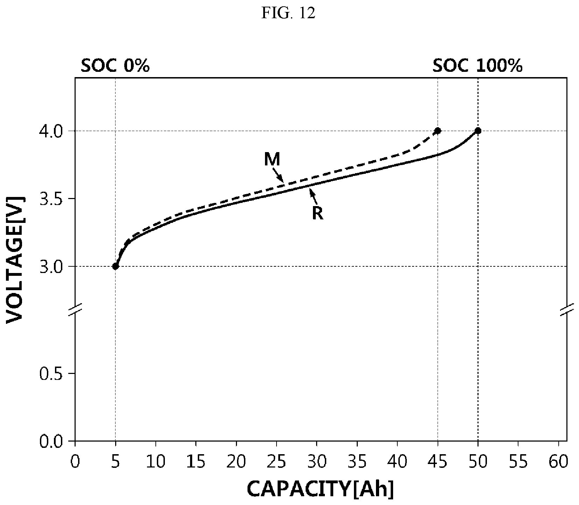

FIG. 12 is a graph referenced to for explaining an example of the measurement full-cell profile M of the target battery. In the graph of FIG. 12, the horizontal axis (X-axis) represents capacity (Ah) and the vertical axis (Y-axis) represents voltage (V).

The profile correcting unit 120 may be configured to compare the measurement full-cell profile M and at least one comparison full-cell profile. Here, the comparison full-cell profile may be the result of synthesizing the adjusted positive electrode profile and the adjusted negative electrode profile based on the criterion positive electrode profile Rp and the criterion negative electrode profile Rn, respectively, stored in the storage unit 140.

In other words, when the criterion full-cell profile R is the result of subtracting a part of the criterion negative electrode profile Rn from a part of the criterion positive electrode profile Rp, the comparison full-cell profile may be said to be the result of subtracting a part of the adjusted negative electrode profile from a part of the adjusted positive electrode profile.

The profile correcting unit 120 may generate at least one comparison full-cell profile by directly adjusting the criterion positive electrode profile Rp and the criterion negative electrode profile Rn. Alternatively, at least one comparison full-cell profile may be secured in advance based on the criterion positive electrode profile Rp and the criterion negative electrode profile Rn and stored in the storage unit 140. In this case, the profile correcting unit 120 may obtain the comparison full-cell profile from the storage unit 140.

The profile correcting unit 120 may generate a plurality of comparison full-cell profiles from the criterion positive electrode profile Rp and the criterion negative electrode profile Rn by repeating the process of adjusting each of the criterion positive electrode profile Rp and the criterion negative electrode profile Rn to various levels and then synthesizing them. The comparison full-cell profile may also be called an 'adjusted criterion full-cell profile'.

The profile correcting unit 120 may specify a specific comparison full-cell profile that has a minimum error with the measurement full-cell profile M among the plurality of comparison full-cell profiles.

Next, the profile correcting unit 120 may determine the adjusted positive electrode profile and the adjusted negative electrode profile corresponding to the specified comparison full-cell profile as the positive electrode profile and the negative electrode profile representing the current state of the battery. In the following, it should be noted that the positive electrode profile is a finally determined adjusted positive electrode profile, and the negative electrode profile is a finally determined adjusted negative electrode profile.

In relation to this, various methods known at the filing time of the present disclosure may be employed to determine the error between two profiles, each of which may be expressed in a two-dimensional coordinate system. For example, the integral value of the absolute value of the area between two profiles or RMSE (Root Mean Square Error) may be used as the error between two profiles.

According to this configuration of the present disclosure, various state information about the battery may be obtained based on the finally determined positive electrode profile and negative electrode profile. The finally determined positive electrode profile and negative electrode profile correspond to the comparison full-cell profile most similar to the measurement full-cell profile. In other words, it may be said that the comparison full-cell profile generated by synthesizing the finally determined positive electrode profile and negative electrode profile is almost identical to measurement full-cell profile M in terms of shape.

Therefore, according to the present disclosure, the positive electrode profile and the negative electrode profile of the battery may be obtained even without disassembling the battery.

If the battery is a new battery, the positive electrode profile and the negative electrode profile of the battery may be analyzed to more easily diagnose whether a defect has occurred in the battery and, if so, what type of defect it is.

In addition, if the battery is already being used, it is possible to determine the extent to which the battery has deteriorated for each deterioration item through the positive electrode profile and the negative electrode profile of the battery.

Furthermore, according to the present disclosure, the positive electrode profile and the negative electrode profile of the battery may be obtained through a simple process. Even if only one criterion positive electrode profile Rp and one criterion negative electrode profile Rn are stored in the storage unit 140, the present disclosure may be implemented. That is, there is no need to store a plurality of criterion positive electrode profiles Rp and/or a plurality of criterion negative electrode profiles Rn in the storage unit 140. Accordingly, the storage capacity of the storage unit 140 does not need to be high, and there is no need to conduct numerous preliminary tests required to secure a plurality of criterion positive electrode profiles Rp and/or a plurality of criterion negative electrode profiles Rn.

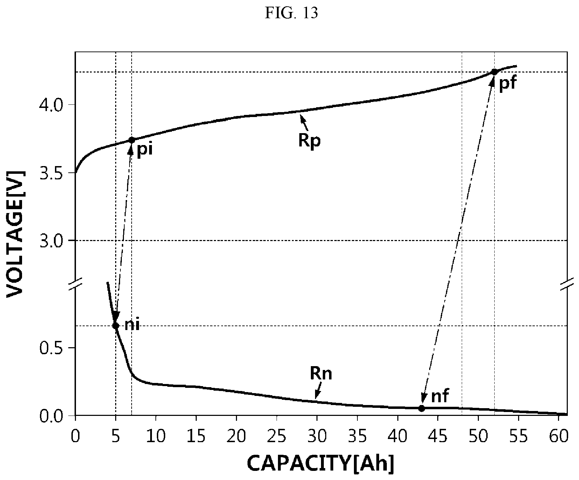

FIGS. 13 to 15 are diagrams referenced to for explaining an example of a procedure for generating a comparison full-cell profile used for comparison with the measurement full-cell profile M according to an embodiment of the present disclosure.

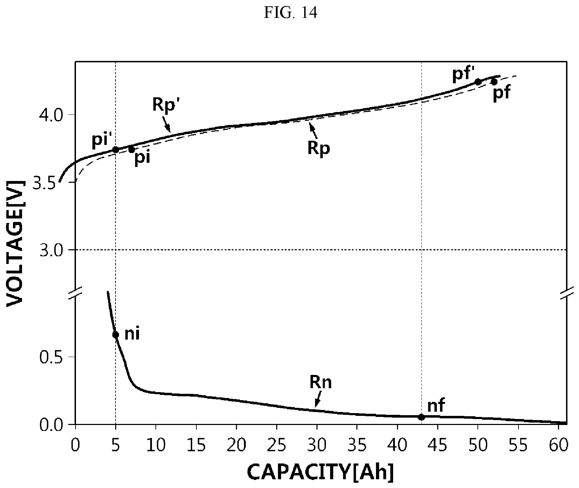

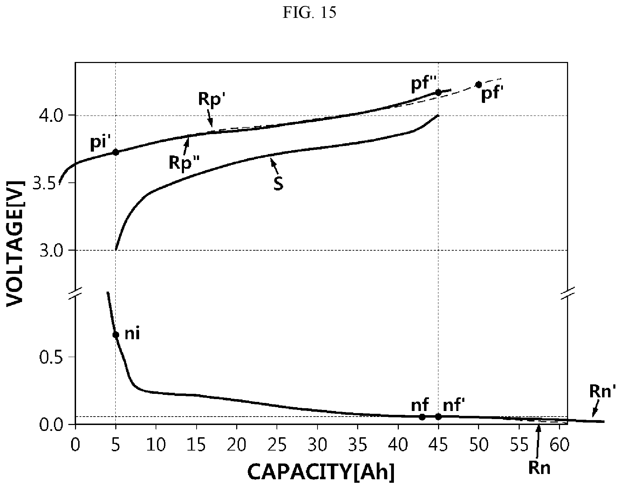

The procedure for generating a comparison full-cell profile, which will be described with reference to FIGS. 13 to 15, proceeds in the following order: a first process that sets four points (positive electrode participation initiating point, positive electrode participation finalizing point, negative electrode participation initiating point, negative electrode participation finalizing point) to correspond to the voltage range of interest (see FIG. 13), a second process that performs profile shifting (see FIG. 14), and a third process that performs capacity scaling (see FIG. 15). That is, the procedure for generating a comparison full-cell profile according to an embodiment of the present disclosure includes the first to third processes.

First, referring to FIG. 13, the criterion positive electrode profile Rp and the criterion negative electrode profile Rn are the same as those shown in FIG. 11.

The profile correcting unit 120 determines a positive electrode participation initiating point pi, a positive electrode participation finalizing point pf, a negative electrode participation initiating point ni, and a negative electrode participation finalizing point nf on the criterion positive electrode profile Rp and the criterion negative electrode profile Rn.

Either the positive electrode participation initiating point pi or the negative electrode participation initiating point ni depends on the other.

As an example, the profile correcting unit 120 divides the positive electrode voltage range from the starting point of the criterion positive electrode profile Rp to the end point (or second setting voltage) into a plurality of micro voltage sections, and then set the boundary point of two adjacent micro voltage sections among the plurality of micro voltage sections as the positive electrode participation initiating point pi. Each micro voltage section may have a predetermined size (e.g., 0.01 V). Next, the profile correcting unit 120 may set a point on the criterion negative electrode profile Rn, which is smaller than the positive electrode participation initiating point pi by the first setting voltage (e.g., 3 V), as the negative electrode participation initiating point ni.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation initiating point ni. Next, the profile correcting unit 120 may search for a point, which is greater than the negative electrode participation initiating point ni by the first setting voltage, from the criterion positive electrode profile Rp and set the searched point as the positive electrode participation initiating point pi.

Also, either the positive electrode participation finalizing point pf and the negative electrode participation finalizing point nf depends on the other.

As an example, the profile correcting unit 120 may divide the voltage range from the second setting voltage to the end point of the criterion positive electrode profile Rp into a plurality of micro voltage sections of a predetermined size, and then set the boundary point of two adjacent micro voltage sections among the plurality of micro voltage sections as the positive electrode participation finalizing point pf. Next, the profile correcting unit 120 may set a point on the criterion negative electrode profile Rn, which is smaller than the positive electrode participation finalizing point pf by a second setting voltage (e.g., 4 V), as the negative electrode participation finalizing point nf.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation finalizing point nf. Next, the profile correcting unit 120 may search for a point, which is greater than the negative electrode participation finalizing point nf by a second setting voltage, from the criterion positive electrode profile Rp and set the searched point as the positive electrode participation finalizing point pf.

If the determination of the positive electrode participation initiating point pi, the positive electrode participation finalizing point pf, the negative electrode participation initiating point ni, and the negative electrode participation finalizing point nf is completed as above, the profile correcting unit 120 shifts at least one of the criterion positive electrode profile Rp and the criterion negative electrode profile Rn to the left or right along the horizontal axis (capacity axis).

Referring to FIG. 14, the profile correcting unit 120 may shift the criterion positive electrode profile Rp and/or the criterion negative electrode profile Rn so that the capacity values of the positive electrode participation initiating point pi and the negative electrode participation initiating point ni match.

Alternatively, the profile correcting unit 120 may shift the criterion positive electrode profile Rp and/or the criterion negative electrode profile Rn so that the capacity values of the positive electrode participation finalizing point pf and the negative electrode participation finalizing point nf match.

FIG. 14 shows the situation that the adjusted criterion positive electrode profile Rp' is generated by shifting only the criterion positive electrode profile Rp to the left, and as a result, the voltage of the positive electrode participation initiating point pi' matches the voltage of the negative electrode participation initiating point ni. The adjusted criterion positive electrode profile Rp' is the result of applying an adjustment procedure of shifting to the left by the voltage difference between the positive electrode participation initiating point pi and the negative electrode participation initiating point ni to the criterion positive electrode profile Rp. Therefore, the two points pi, pi' differ only in capacity value and have the same voltage. The two points pf, pf' differ only in capacity value and have the same voltage.

When the adjustment result profiles Rp', Rn in which at least one of the criterion positive electrode profile Rp and the criterion negative electrode profile Rn is shifted are secured, the profile correcting unit 120 scales the capacity range of at least one of the adjustment result profiles Rp', Rn.

According to the example shown in FIG. 15, the profile correcting unit 120 performs an additional adjustment procedure to shrink or expand at least one of the adjusted criterion positive electrode profile Rp' and the adjusted criterion negative electrode profile Rn along the horizontal axis (capacity axis).

Referring to FIG. 15, the profile correcting unit 120 may generate an adjusted criterion positive electrode profile Rp" by shrinking or expanding the adjusted criterion positive electrode profile Rp' so that the size of the capacity range between the two points pi', pf' of the adjusted criterion positive electrode profile Rp' matches the size of the capacity range of the measurement full-cell profile M. At this time, any one of the two points pi', pf' may be fixed. Accordingly, the capacity difference between the two points pi', pf" of the adjusted criterion positive electrode profile Rp" may be matched to the size of the capacity range of the measurement full-cell profile M.

In addition, the profile correcting unit 120 may generate an adjusted criterion negative electrode profile Rn' by shrinking or expanding the criterion negative electrode profile Rn so that the size of the capacity range between two points ni, nf of the criterion negative electrode profile Rn matches the size of the capacity range of the measurement full-cell profile M. At this time, any one of the two points ni, nf may be fixed. Accordingly, the capacity difference between the two points ni, nf' of the adjusted criterion negative electrode profile Rn' may be matched to the capacity range of the measurement full-cell profile M.

In FIG. 15, the adjusted criterion positive electrode profile Rp" is the result of shrinkage of the adjusted criterion positive electrode profile Rp' shown in FIG. 14, and the adjusted criterion negative electrode profile Rn' is the result of expansion of the criterion negative electrode profile Rn shown in FIG. 14.

The positive electrode participation finalizing point pf" on the adjusted criterion positive electrode profile Rp" corresponds to the positive electrode participation finalizing point pf on the adjusted criterion positive electrode profile Rp'. The negative electrode participation finalizing point nf' on the adjusted criterion negative electrode profile Rn' corresponds to the negative electrode participation finalizing point nf on the criterion negative electrode profile Rn.

The capacity difference between the positive electrode participation initiating point pi' and the positive electrode participation finalizing point pf" of the adjusted criterion positive electrode profile Rp" corresponds to the size of the capacity range of the measurement full-cell profile M. Likewise, the capacity difference between the negative electrode participation initiating point ni and the negative electrode participation finalizing point nf' of the adjusted criterion negative electrode profile Rn' corresponds to the size of the capacity range of the measurement full-cell profile M.

In addition, the capacity difference between two points pi', pf" of the adjusted criterion positive electrode profile Rp" matches the capacity difference between two points ni, nf' of the adjusted criterion negative electrode profile Rn'. The profile correcting unit 120 may generate the comparison full-cell profile S by subtracting the portion between two points ni, nf' of the adjusted criterion negative electrode profile Rn' from the portion between two points pi', pf" of the adjusted criterion positive electrode profile Rp".

The profile correcting unit 120 may calculate the error (profile error) between the comparison full-cell profile S and the measurement full-cell profile M. When the error between the comparison full-cell profile S and the measurement full-cell profile M is minimized, the adjusted criterion positive electrode profile Rp" corresponding to the comparison full-cell profile S may be determined as the adjusted positive electrode profile, and the adjusted criterion negative electrode profile Rn' may be determined as the adjusted negative electrode profile.

The profile correcting unit 120 may map at least two of the adjusted criterion positive electrode profile Rp", the adjusted criterion negative electrode profile Rn', the positive electrode participation initiating point pi', the positive electrode participation finalizing point pf", the negative electrode participation initiating point ni, the negative electrode participation finalizing point nf', the first scale factor, the second scale factor, the comparison full-cell profile S, and the profile error to each other and record in the storage unit 140. Here, the first scale factor may represent the rate of the capacity difference between two points pi', pf" relative to the capacity difference between two points pi0, pf0. The second scale factor may represent the rate of the capacity difference between two points ni, nf' relative to the capacity difference between two points ni0, nf0.

In addition, the profile correcting unit 120 may calculate the positive electrode change rate (ps) of the adjusted criterion positive electrode profile Rp" for the criterion positive electrode profile Rp. Also, the profile correcting unit 120 may calculate the negative electrode change rate (ns) of the adjusted criterion positive electrode profile Rn' for the criterion negative electrode profile Rn. In this case, the profile correcting unit 120 may determine the first scale factor as the positive electrode change rate (ps) and determine the second scale factor as the negative electrode change rate (ns).

Meanwhile, as described above, when the positive electrode voltage range of the criterion positive electrode profile Rp is divided into a plurality of micro voltage sections, the boundary point of two adjacent micro voltage sections among the plurality of micro voltage sections may be set as the positive electrode participation initiating point pi.

For example, if the positive electrode voltage range of the criterion positive electrode profile Rp is divided into one hundred small voltage ranges, there may be one hundred boundary points that may be set as the positive electrode participation initiating point pi. In addition, if the voltage range equal to or greater than the second setting voltage in the criterion positive electrode profile Rp is divided into 40 small voltage ranges, there may be 40 boundary points that may be set as the positive electrode participation finalizing point pf. In this case, up to 4000 different comparison full-cell profiles may be generated.

Of course, it will be easy to understand by those skilled in the art that as the size of the micro voltage section decreases, the number of comparison full-cell profiles that may be maximally generated increases, and conversely, as the size of the micro voltage section increases, the number of comparison full-cell profiles that may be maximally generated decreases.

The profile correcting unit 120 may identify the minimum value among the profile errors of the plurality of comparison full-cell profile generated as described above, and then obtain information mapped to the minimum profile error (e.g., at least one of the positive electrode participation initiating point pi, the positive electrode participation finalizing point pf, the negative electrode participation initiating point ni, the negative electrode participation finalizing point nf, the positive electrode change rate (ps), the negative electrode change rate (ns), and the capacity ratio between the positive electrode and the negative electrode) from the storage unit 140.

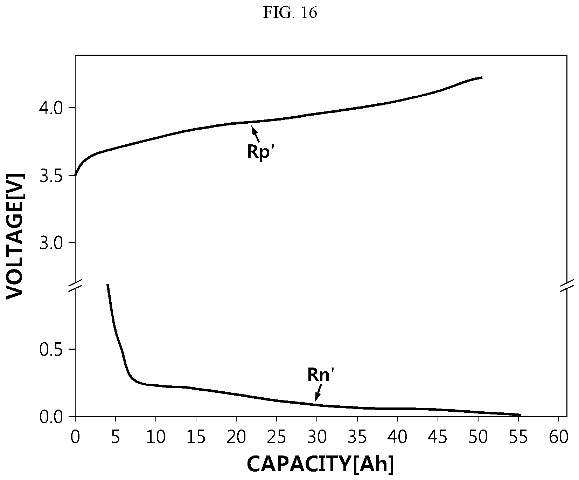

FIGS. 16 to 18 are diagrams referenced to for explaining another example of a procedure for generating a comparison full-cell profile used for comparison with the measurement full-cell profile M according to an embodiment of the present disclosure.

For reference, the embodiments shown in FIGS. 16 to 18 are independent from the embodiments shown in FIGS. 13 to 15. Accordingly, terms or symbols commonly used in describing the embodiments shown in FIGS. 13 to 15 and the embodiments shown in FIGS. 16 to 18 should be understood as being limited to each embodiment.

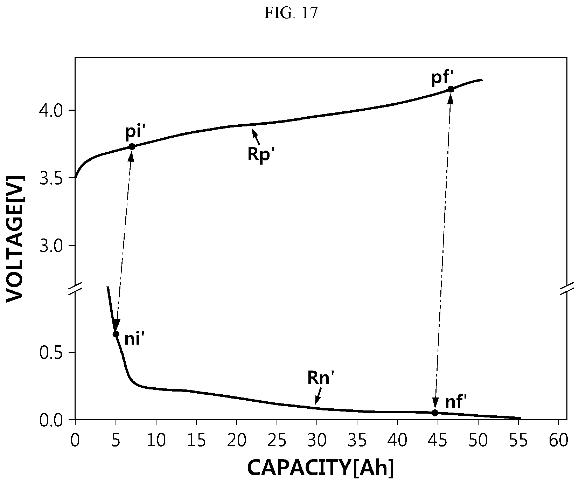

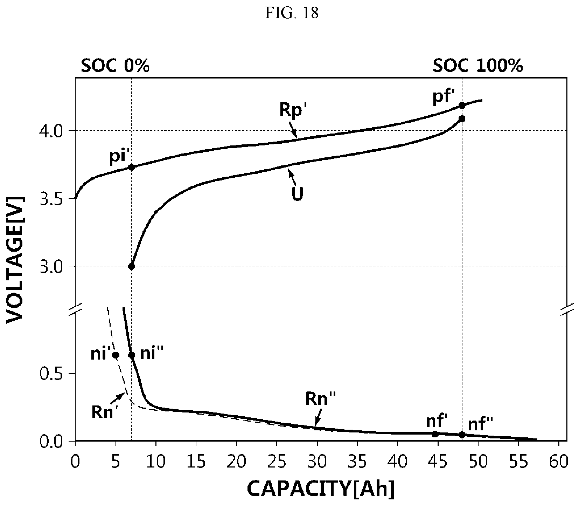

The generation procedure of the comparison full-cell profile to be explained with reference to FIGS. 16 to 18 proceeds in the following order: a fourth process for performing capacity scaling (see FIG. 16), a fifth process of setting four points (the positive electrode participation initiating point, the positive electrode participation finalizing point, the negative electrode participation initiating point and the negative electrode participation finalizing point (see FIG. 17), and a sixth process of performing profile shift (see FIG. 18). That is, the generation procedure of the comparison full-cell profile according to another embodiment of the present disclosure includes the fourth to sixth processes.

First, referring to FIG. 16, the criterion positive electrode profile Rp and the criterion negative electrode profile Rn are the same as those shown in FIG. 11.

The profile correcting unit 120 generates an adjusted criterion positive electrode profile Rp' and an adjusted criterion negative electrode profile Rn' by applying the first scale factor and the second scale factor selected from the scaling value range to the criterion positive electrode profile Rp and the criterion negative electrode profile Rn, respectively.

The scaling value range may be predetermined or may vary depending on the rate of the size of the capacity range of the measurement full-cell profile M relative to the size of the capacity range of the criterion full-cell profile R. As an example, assuming that the first scale factor and the second scale factor may be selected among the values spaced by 0.1% (i.e., 90%, 90.1%, 90.2%, ..., 98.9%, 99%) in the scaling numerical range (e.g., 90 to 99%), 91 values may be selected as the first scale factor and the second scale factor, respectively. In this case, up to 8,281 adjusted profile pairs may be generated to $91 \times 91 = 8,281$ adjustment levels (combination of first scale factor and second scale factor). The adjusted profile pair refers to a combination of the adjusted criterion positive electrode profile and the adjusted criterion negative electrode profile.

FIG. 16 shows an example in which the adjusted criterion positive electrode profile Rp' and the adjusted criterion negative electrode profile Rn' are the results of applying a first scale factor and a second scale factor less than 100% to the criterion positive electrode profile Rp and the criterion negative electrode profile Rn, respectively.

Since the first scale factor and the second scale factor are less than 100%, the adjusted criterion positive electrode profile Rp' is the shrinkage of the criterion positive electrode profile Rp along the horizontal axis, and the adjusted criterion negative electrode profile Rn' is also the shrinkage of the criterion negative electrode profile Rn along the horizontal axis. To facilitate understanding, the example is illustrated in the form where the starting point of each of the positive electrode profile Rp and the criterion negative electrode profile Rn is fixed and the remaining portions are reduced to the left along the horizontal axis.

Referring to FIG. 17, the profile correcting unit 120 determines the positive electrode participation initiating point pi', the positive electrode participation finalizing point pf', the negative electrode participation initiating point ni' and the negative electrode participation finalizing point nf' on the adjusted criterion positive electrode profile Rp' and the adjusted criterion negative electrode profile Rn'.

Either the positive electrode participation initiating point pi' or the negative electrode participation initiating point ni' may depend on the other. Additionally, either the positive electrode participation finalizing point pf' or the negative electrode participation finalizing point nf' may depend on the other. Additionally, either the positive electrode participation initiating point pi' or the positive electrode participation finalizing point pf' may be set based on the other.

That is, if any one of the positive electrode participation initiating point pi', the positive electrode participation finalizing point pf', the negative electrode participation initiating point ni', and the negative electrode participation finalizing point nf' is set, the remaining three points may be set automatically by the first setting voltage, the second setting voltage and/or the size of the capacity range of the measurement full-cell profile M (e.g., charging capacity of SOC 0% to 100%).

As an example, the profile correcting unit 120 may divide the positive electrode voltage range from the start point of the adjusted criterion positive electrode profile Rp' to the end point (or second setting voltage) into a plurality of micro voltage section, and then set the boundary point of two adjacent micro voltage sections among the plurality of micro voltage sections as the positive electrode participation initiating point pi'. Next, the profile correcting unit 120 may set the point on the adjusted criterion negative electrode profile Rn, which is smaller than the positive electrode participation initiating point pi' by the first setting voltage (e.g., 3 V), as the negative electrode participation initiating point ni'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent voltage sections among the plurality of micro voltage sections as the negative electrode participation initiating point ni'. Next, the profile correcting unit 120 may search for a point, which is greater than the negative electrode participation initiating point ni' by the first setting voltage, from the criterion positive electrode profile Rp and set the searched point as the positive electrode participation initiating point pi'.

As another example, the profile correcting unit 120 may divide the voltage range from the second setting voltage to the end point of the adjusted criterion positive electrode profile Rp' into a plurality of micro voltage sections of a predetermined size, and then set the boundary point of the two micro voltage sections among the plurality of micro voltage sections as the positive electrode participation finalizing point pf. Next, the profile correcting unit 120 may search for a point, which is smaller than the positive electrode participation finalizing point pf' by the second setting voltage (e.g., 4 V), in the adjusted criterion negative electrode profile Rn', and set the searched point as the negative electrode participation finalizing point nf'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent micro voltage sections among the plurality of micro voltage sections as the negative electrode participation finalizing point nf'. Next, the profile correcting unit 120 may search for a point, which is greater than the negative electrode participation finalizing point nf' by the second setting voltage, from the adjusted criterion positive electrode profile Rp' and set the searched point as the positive electrode participation finalizing point pf'.

If any one of the positive electrode participation initiating point pi', the positive electrode participation finalizing point pf', the negative electrode participation initiating point ni', and the negative electrode participation finalizing point nf' is determined, the profile correcting unit 120 may additionally determine the remaining points based on the determined point.

As an example, if the positive electrode participation initiating point pi' is determined first, the profile correcting unit 120 may set the point on the adjusted criterion positive electrode profile Rp', which has a capacity value that is larger than the capacity value of the positive electrode participation initiating point pi' by the size of the capacity range of the measurement full-cell profile M, as the positive electrode participation finalizing point pf'. Additionally, the profile correcting unit 120 may search for a point, which is lower than the positive electrode participation initiating point pi' by the first setting voltage, from the adjusted criterion negative electrode profile Rn' and set the searched point as the negative electrode participation initiating point ni'. In addition, the profile correcting unit 120 may set a point on the adjusted criterion negative electrode profile Rn', which has a capacity value larger than the capacity value of the negative electrode participation initiating point ni' by the size of the capacity range of the measurement full-cell profile M, as the negative electrode participation finalizing point nf'.

As another example, if the positive electrode participation finalizing point pf' is determined first, the profile correcting unit 120 may set a point on the adjusted criterion positive electrode profile Rp', which has a capacity value smaller than the capacity value of the positive electrode participation finalizing point pf' by the size of the capacity range of the measurement full-cell profile M, as the positive electrode participation initiating point pi'. Additionally, the profile correcting unit 120 may search for a point, which is lower than the positive electrode participation finalizing point pf' by the second setting voltage, from the adjusted criterion negative electrode profile Rn' and set the searched point as the negative electrode participation finalizing point nf'. In addition, the profile correcting unit 120 may set a point on the adjusted criterion negative electrode profile Rn', which has a capacity value smaller than the capacity value of the negative electrode participation finalizing point nf' by the size of the capacity range of the measurement full-cell profile M, as the negative electrode participation initiating point ni'.

As still another example, if the negative electrode participation initiating point ni' is determined, the profile correcting unit 120 may set a point on the criterion negative electrode profile Rn', which has a capacity value larger than the capacity value of the negative electrode participation initiating point ni' by the size of the capacity range of the measurement full-cell profile M, as the negative electrode participation finalizing point nf'. Additionally, the profile correcting unit 120 may search for a point, which is higher than the negative electrode participation initiating point ni' by the first setting voltage, from the adjusted criterion positive electrode profile Rp' and set the searched point as the positive electrode participation initiating point pi'. In addition, the profile correcting unit 120 may set a point on the adjusted criterion positive electrode profile Rp', which has a capacity value greater than the capacity value of the positive electrode participation initiating point pi' by the size of the capacity range of the measurement full-cell profile M, as the positive electrode participation finalizing point pf'.

As still another example, if the negative electrode participation finalizing point nf' is determined, the profile correcting unit 120 may set a point on the criterion negative electrode profile Rn', which has a capacity value smaller than the capacity value of the negative electrode participation finalizing point nf' by the size of the capacity range of the measurement full-cell profile M, as the negative electrode participation finalizing point ni'. Additionally, the profile correcting unit 120 may search for a point, which is higher than the negative electrode participation finalizing point nf' by the second setting voltage, from the adjusted criterion positive electrode profile Rp' and set the searched point as the positive electrode participation finalizing point pf'. In addition, the profile correcting unit 120 may set a point on the adjusted criterion positive electrode profile Rp', which has a capacity value smaller than the capacity value of the positive electrode participation finalizing point pf' by the size of the capacity range of the measurement full-cell profile M, as the positive electrode participation initiating point pi'.

If the determination of the positive electrode participation initiating point pi', the positive electrode participation finalizing point pf', the negative electrode participation initiating point ni' and the negative electrode participation finalizing point nf' is completed based on the pair of first scale factor and second scale factor, the profile correcting unit 120 may shift at least one of the adjusted criterion positive electrode profile Rp' and the adjusted criterion negative electrode profile Rn' along the horizontal axis so that the capacity values of the positive electrode participation initiating point pi' and the negative electrode participation initiating point ni' match or the capacity values of the positive electrode participation finalizing point pf' and the negative electrode participation finalizing point nf' match.

The adjusted criterion negative electrode profile Rn" shown in FIG. 18 is obtained by shifting only the adjusted criterion negative electrode profile Rn' shown in FIG. 17 to the right. Accordingly, the capacity values of the positive electrode participation initiating point pi' and the negative electrode participation initiating point ni" do not match each other. In this regard, since the capacity difference between the positive electrode participation initiating point pi' and the positive electrode participation finalizing point pf' is the same as the capacity difference between the negative electrode participation initiating point ni' and the negative electrode participation finalizing point nf', if the capacity values of the positive electrode participation initiating point pi' and the negative electrode participation initiating point ni" match each other, the capacity values of the positive electrode participation finalizing point pf' and the negative electrode participation finalizing point nf" also match each other.

Referring to FIG. 18, the profile correcting unit 120 may generate the comparison full-cell profile U by subtracting a partial profile between two points pi', pf' of the adjusted criterion positive electrode profile Rp' from the partial profile between into two points ni", nf" of the adjusted criterion negative electrode profile Rn".

The profile correcting unit 120 may calculate the error (profile error) between the comparison full-cell profile U and the measurement full-cell profile M. When the error between the comparison full-cell profile U and the measurement full-cell profile M is minimized, the adjusted criterion positive electrode profile Rp' corresponding to the comparison full-cell profile U may be determined as the adjusted positive electrode profile, and the adjusted criterion negative electrode profile Rn" may be determined as the adjusted negative electrode profile.

The profile correcting unit 120 may map at least two of the adjusted criterion positive electrode profile Rp', the adjusted criterion negative electrode profile Rn", the positive electrode participation initiating point pi', the positive electrode participation finalizing point pf', the negative electrode participation initiating point ni", the negative electrode participation finalizing point nf", the positive electrode change rate ps, the negative electrode change rate ns, the comparison full-cell profile U, and the profile error with each other and record in the storage unit 140.

Here, the profile correcting unit 120 may calculate the positive electrode change rate ps of the adjusted criterion positive electrode profile Rp' for the criterion positive electrode profile Rp. Also, the profile correcting unit 120 may calculate the negative electrode change rate ns of the adjusted criterion negative electrode profile Rn" for the criterion negative electrode profile Rn. For example, the profile correcting unit 120 may determine the first scale factor as the positive electrode change rate ps and determine the second scale factor as the negative electrode change rate ns.

As described above, the profile correcting unit 120 may generate a comparison full-cell profile corresponding to each pair of first scale factor and second scale factor selected from the scaling value range. Since the pair of first scale factor and second scale factor is plural, it is obvious that the comparison full-cell profile will also be generated in plural. The profile correcting unit 120 may identify the minimum value among the profile errors of the plurality of comparison full-cell profiles and then obtain information mapped to the minimum profile error from the storage unit 140.

The apparatus 100 for diagnosing a battery according to the present disclosure may be connected to a display device (not shown) and output information on a battery diagnosed as being in an abnormal state. Because of this, the information about the battery diagnosed as being in an abnormal state may be displayed on the display device.

The apparatus 100 for diagnosing a battery according to the present disclosure may be connected to an alarm device (not shown) and output information on a battery diagnosed as being in an abnormal state to operate the alarm device.

The apparatus 100 for diagnosing a battery according to the present disclosure may be applied to the BMS. In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the profile obtaining unit 110, the profile correcting unit 120, the control unit 130 and the storage unit 140 of the apparatus 100 for diagnosing a battery may be implemented as components of a BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

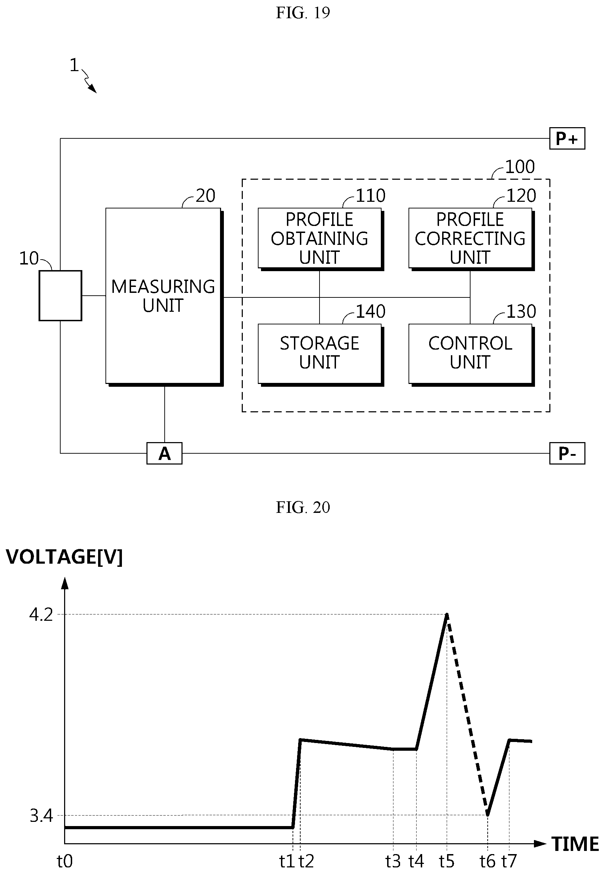

FIG. 19 is a diagram showing an exemplary configuration of the battery pack according to another embodiment of the present disclosure.

As illustrated in FIG. 19, the battery pack 1 according to the present disclosure may include at least one battery 10, a measuring unit 20, and the apparatus 100 for diagnosing a battery according to the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the positive electrode terminal and the negative electrode terminal of the battery 10. Additionally, the measuring unit 20 may measure the voltage of the battery 10 by measuring the positive electrode potential and the negative electrode potential of the battery 10 and calculating the difference between the positive electrode potential and the negative electrode potential.

In addition, the measuring unit 20 may be connected to a current measurement unit A. For example, the current measurement unit A may be an ammeter or shunt resistor that may measure the charging current and discharging current of the battery 10. The measuring unit 20 may calculate the charging amount by measuring the charging current of the battery 10 using the current measurement unit A. Additionally, the measuring unit 20 may calculate the discharge amount by measuring the discharge current of the battery 10 through the current measurement unit A.

For example, the information about the voltage and capacity of the battery 10 measured by the measuring unit 20 may be transmitted to the profile obtaining unit 110. Additionally, the profile obtaining unit 110 may directly generate a battery profile BP based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the battery profile BP.

As still another example, the measuring unit 20 may directly generate a battery profile BP based on the measured information about the voltage and capacity of the battery 10. In this case, the generated battery profile BP may be transmitted to the profile obtaining unit 110 and also be stored in the storage unit 140.

A charge/discharge device or load may be connected to the positive electrode terminal P+ and the negative electrode terminal P- of the battery pack 1.

FIG. 20 is a diagram showing a battery cell manufacturing process of a battery manufacturing system according to still another embodiment of the present disclosure. Specifically, FIG. 20 is a diagram schematically showing the process of activating a manufactured battery cell over time.

Referring to FIG. 20, the aging process proceeds in the first step from the t0 time point to the t1 time point. Here, the aging process refers to a process of leaving the battery cell under specific conditions. In the first step, the electrolyte may be impregnated in the electrode of the battery.

Primary charging proceeds in the second step from the t1 time point to the t2 time point. In the second step, a film layer (SEI, solid electrolyte interphase) may be formed on the negative electrode.

A high temperature aging process proceeds in the third step from the t2 time point to the t3 time point. For example, in the third step, aging occurs under high temperature conditions of 60°C, and the film layer formed in the second step may be stabilized.

The degassing process proceeds in the fourth step from the t3 time point to the t4 time point. In the fourth step, the gas contained inside the battery cell may be removed.

The process of charging the battery cell proceeds in the fifth step from the t4 time point to the t5 time point. The battery cell discharge process proceeds in the sixth step from the t5 time point to the t6 time point. Here, the fifth step and the sixth step may be combined and referred to as the battery cell capacity inspection process. Generally, the sixth step is a step of detecting a defect in the battery cell while discharging a fully charged battery cell, and is a process step of discharging the battery cell at a discharge C-rate determined in consideration of the inspection time and inspection accuracy. For example, in the sixth step, the battery cell is discharged at 0.3 C, and the battery profile BP for capacity and voltage may be obtained during the discharge process. Also, based on the obtained battery profile BP, it may be detected whether the battery cell is defective as described above.

In the seventh step from the t6 time point to the t7 time point, the shipping and charging process to ship the battery cell is carried out.

The apparatus 100 for diagnosing a battery according to an embodiment of the present disclosure may obtain a battery profile BP generated in the discharge process of the sixth step. Also, by removing the overpotential included in the battery profile BP using the overpotential profile OP corresponding to the target C-rate set in the discharge process, the corrected profile CP for the plurality of battery cells may be obtained. Also, the apparatus 100 for diagnosing a battery may diagnose the state of the plurality of battery cells based on the plurality of corrected profiles CP. In other words, the apparatus 100 for diagnosing a battery may be used in the battery cell activation process step to quickly and accurately diagnose defects in the manufactured battery cell. In particular, the apparatus 100 for diagnosing a battery has an advantage of detecting defective battery cells more accurately because it diagnoses the state of the battery cell after removing the overpotential that may be included in the battery profile BP obtained in the capacity inspection process.

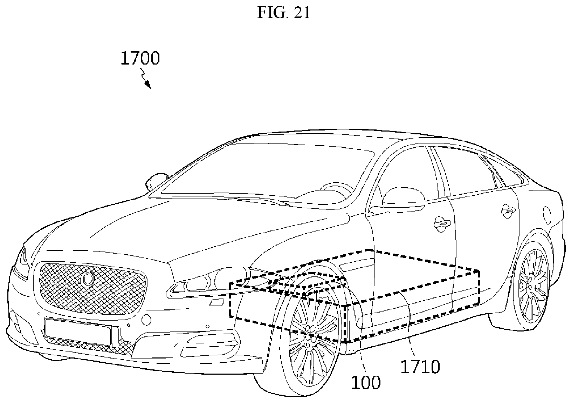

FIG. 21 is a diagram schematically showing an exemplary configuration of a vehicle according to still another embodiment of the present disclosure.

Referring to FIG. 21, the battery pack according to an embodiment of the present disclosure may be included in a vehicle 1700 such as an electric vehicle (EV) or a hybrid vehicle (HV). In addition, the battery pack 1710 may drive the vehicle 1700 by supplying power to a motor through an inverter included in the vehicle 1700. Here, the battery pack 1710 may include the apparatus 100 for diagnosing a battery. That is, the vehicle 1700 may include the apparatus 100 for diagnosing a battery.

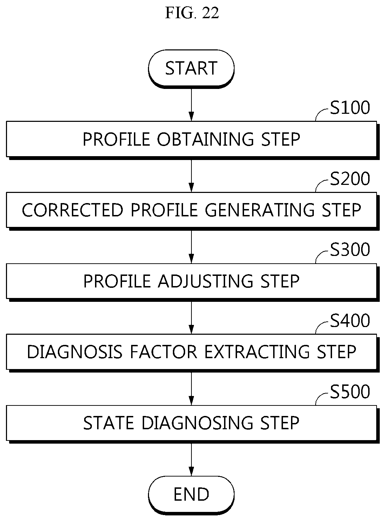

FIG. 22 is a diagram schematically showing a method for diagnosing a battery according to still another embodiment of the present disclosure.

The method for diagnosing a battery may include a profile obtaining step (S100), a corrected profile generating step (S200), a profile adjusting step (S300), a diagnosis factor extracting step (S400), and a state diagnosing step (S500).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining each of a plurality of battery profiles BP indicating the correspondence relationship between voltage and capacity of each of the plurality of batteries, and may be performed by the profile obtaining unit 110.

For example, the profile obtaining unit 110 may directly receive the battery profile BP from the outside. That is, the profile obtaining unit 110 may obtain the battery profile BP by receiving the battery profile BP by being connected to the outside wired and/or wirelessly.

As another example, the profile obtaining unit 110 may receive battery information about the voltage (V) and capacity (Q) of the battery. Additionally, the profile obtaining unit 110 may generate a battery profile BP based on the received battery information. That is, the profile obtaining unit 110 may obtain the battery profile BP by directly generating the battery profile BP based on the battery information.

The corrected profile generating step (S200) is a step for generating a plurality of corrected profiles CP by correcting the plurality of battery profiles BP based on a preset overpotential profile OP, and may be performed by the profile correcting unit 120.

Specifically, the profile correcting unit 120 may remove the overpotential profile OP from the battery profile BP. For example, the profile correcting unit 120 may calculate the difference between the voltage of the battery profile BP and the overpotential of the overpotential profile OP for the same capacity. The profile correcting unit 120 may generate a corrected profile CP by calculating the difference between the voltage of the battery profile BP and the overpotential of the overpotential profile OP at the total capacity.

The profile adjusting step (S300) is a step of generating an adjusted positive electrode profile and an adjusted negative electrode profile corresponding to each battery by adjusting a predetermined criterion positive electrode profile and a predetermined criterion negative electrode profile to correspond to each of the plurality of corrected profiles CP, and may be performed by the profile correcting unit 120.

For example, the profile correcting unit 120 may generate a plurality of comparison full-cell profiles by shifting the criterion positive electrode profile and the criterion negative electrode profile or scaling the capacity thereof, and specify a comparison full-cell profile having a minimum error with the corrected profile CP among the plurality of comparison full-cell profiles. Also, an adjusted positive electrode profile and an adjusted negative electrode profile corresponding to the specified comparison full-cell profile may be determined.

The diagnosis factor extracting step (S400) is a step of extracting a diagnosis factor for each battery from at least one of the adjusted positive electrode profile and the adjusted negative electrode profile, and may be performed by the control unit 130.

Specifically, when it is intended to diagnose the battery state related to the positive electrode, the control unit 130 may extract a diagnosis factor related to the positive electrode from the adjusted positive electrode profile. Additionally, when it is intended to diagnose the battery state related to the negative electrode, the control unit 130 may extract a diagnosis factor related to the negative electrode from the adjusted negative electrode profile. Additionally, when it is intended to diagnose the battery state related to both the positive electrode and the negative electrode, the control unit 130 may extract a diagnosis factor related to the positive electrode from the adjusted positive electrode profile and extract a diagnosis factor related to the negative electrode from the adjusted negative electrode profile.

In this case, the positive electrode-related factor may include at least one of a positive electrode start potential, a positive electrode end potential, a positive electrode change rate, and a positive electrode loading amount of the battery based on the adjusted positive electrode profile. Also, the negative electrode-related factor may include at least one of a negative electrode start potential, a negative electrode end potential, a negative electrode change rate, and a negative electrode loading amount of the battery based on the adjusted negative electrode profile. The factors related to both the positive and negative electrodes may include an NP ratio based on a positive electrode loading amount and a negative electrode loading amount.

The state diagnosing step (S500) is a step of diagnosing the state of the plurality of batteries based on the extracted plurality of diagnosis factors, and may be performed by the control unit 130.

For example, the control unit 130 may be configured to select a diagnosis factor that is outside the threshold range TH among the plurality of diagnosis factors in consideration of the distribution of the plurality of diagnosis factors, and diagnose the state of the battery corresponding to the selected diagnosis factor as an abnormal state. Meanwhile, the control unit 130 may be configured to select a diagnosis factor included in the threshold range TH among the plurality of diagnosis factors and diagnose the state of the battery corresponding to the selected diagnosis factor as a normal state.

In addition, after the threshold range (TH) of the diagnosis factor value of the normal battery is determined for each diagnosis factor, a new battery may be diagnosed through a simplified process of determining whether the diagnosis factor value of the battery corresponds to the threshold range.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

    1: battery pack
    10: battery
    20: measuring unit
    100: apparatus for diagnosing a battery
    110: profile obtaining unit
    120: profile correcting unit
    130: control unit
    140: storage unit
    1700: vehicle
    1710: battery pack

## Claims

1. An apparatus for diagnosing a battery, comprising:

    a profile obtaining unit configured to obtain a battery profile representing a correspondence relationship between voltage and capacity of a battery to be diagnosed that is charged or discharged at a predetermined target C-rate;
    a profile correcting unit configured to generate a corrected profile by correcting the battery profile based on an overpotential profile representing overpotential of a criterion battery for each capacity that occurs when the criterion battery is charged or discharged at the target C-rate, and generate an adjusted negative electrode profile adjusted to represent a correspondence relationship between a negative electrode capacity and a negative electrode potential of the battery to be diagnosed using the corrected profile; and
    a control unit configured to extract a negative electrode end potential value from the adjusted negative electrode profile as a diagnosis factor for the battery to be diagnosed, and diagnose a state of the battery to be diagnosed based on the extracted diagnosis factor.

2. The apparatus for diagnosing a battery according to claim 1,
   wherein the overpotential profile is a profile representing a voltage difference for each capacity between a first battery profile of the criterion battery obtained when the criterion battery is charged or discharged at a criterion C-rate and a second battery profile of the criterion battery obtained when the criterion battery is charged or discharged at the target C-rate.

3. The apparatus for diagnosing a battery according to claim 2,
   wherein the profile correcting unit is configured to generate the corrected profile by calculating a voltage difference for each capacity between the battery profile and the overpotential profile.

4. The apparatus for diagnosing a battery according to claim 2, further comprising:

    a storage unit that stores the overpotential profile and other overpotential profiles showing overpotential of the criterion battery for each capacity that occurs when the criterion battery is charged or discharged at a C-rate other than the target C-rate,
    wherein the profile correcting unit is configured to select the overpotential profile corresponding to the target C-rate among overpotential profiles stored in the storage unit and generate the corrected profile using the selected overpotential profile.

5. The apparatus for diagnosing a battery according to claim 1,
   wherein the profile correcting unit is configured to generate a comparison full-cell profile corresponding to the corrected profile by adjusting and mutually synthesizing a predetermined criterion positive electrode profile and a predetermined criterion negative electrode profile, and provide the criterion negative electrode profile adjusted to generate the comparison full-cell profile as the adjusted negative electrode profile.

6. The apparatus for diagnosing a battery according to claim 1,
   wherein the control unit is configured to diagnose the battery to be diagnosed as in an abnormal state when the negative electrode end potential value does not correspond to a predetermined threshold range.

7. The apparatus for diagnosing a battery according to claim 1,
   wherein the control unit is configured to further extract one or more of a negative electrode start potential value, a negative electrode change rate, and a negative electrode loading amount from the adjusted negative electrode profile as a diagnosis factor, and diagnose the state of the battery to be diagnosed based on the extracted diagnosis factors.

8. The apparatus for diagnosing a battery according to claim 7,
   wherein the control unit is configured to diagnose the battery to be diagnosed as in a normal state when values of diagnosis factors of a predetermined number or more among the extracted diagnosis factors fall within threshold ranges respectively corresponding thereto.

9. A battery pack, comprising the apparatus for diagnosing a battery according to any one of claims 1 to 8.

10. A battery manufacturing system, comprising the apparatus for diagnosing a battery according to any one of claims 1 to 8.

11. A vehicle, comprising the apparatus for diagnosing a battery according to any one of claims 1 to 8.

12. A method for diagnosing a battery, comprising:

   a profile obtaining step of obtaining a battery profile representing a correspondence relationship between voltage and capacity of a battery to be diagnosed that is charged or discharged at a predetermined target C-rate;
   a corrected profile generating step of generating a corrected profile by correcting the battery profile based on an overpotential profile representing overpotential of a criterion battery for each capacity that occurs when the criterion battery is charged or discharged at the target C-rate;
   a profile adjusting step of generating an adjusted negative electrode profile adjusted to represent a correspondence relationship between a negative electrode capacity and a negative electrode potential of the battery to be diagnosed using the corrected profile;
   a diagnosis factor extracting step of extracting a negative electrode end potential value from the adjusted negative electrode profile as a diagnosis factor for the battery to be diagnosed; and
   a state diagnosing step of diagnosing a state of the battery to be diagnosed based on the negative electrode end potential value.

FIG. 1

CAPACITY[Ah]

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

START

PROFILE OBTAINING STEP — S100

CORRECTED PROFILE GENERATING STEP — S200

PROFILE ADJUSTING STEP — S300

DIAGNOSIS FACTOR EXTRACTING STEP — S400

STATE DIAGNOSING STEP — S500

END

EP 4 749 309 A1

## INTERNATIONAL SEARCH REPORT

<table>
<tr><td></td><td>International application No.</td></tr>
<tr><td></td><td>PCT/KR2024/012057</td></tr>
</table>

### A. CLASSIFICATION OF SUBJECT MATTER

**G01R 31/396**(2019.01)i; **G01R 31/385**(2019.01)i; **G01R 31/382**(2019.01)i; **G01R 31/374**(2019.01)i; **G01R 19/165**(2006.01)i; **G01R 19/10**(2006.01)i; **B60L 58/10**(2019.01)i

According to International Patent Classification (IPC) or to both national classification and IPC

### B. FIELDS SEARCHED

Minimum documentation searched (classification system followed by classification symbols)

G01R 31/396(2019.01); G01R 19/00(2006.01); G01R 31/36(2006.01); G01R 31/367(2019.01); G01R 31/374(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 과전압 프로파일(overpotential profile), 진단(diagnosis), 보정(compensation), 씨레이트(current rate, C-rate)

### C. DOCUMENTS CONSIDERED TO BE RELEVANT

| Category* | Citation of document, with indication, where appropriate, of the relevant passages | Relevant to claim No. |
|---|---|---|
| A | KR 10-2022-0094042 A (LG ENERGY SOLUTION, LTD.) 05 July 2022 (2022-07-05) See paragraphs [0197]-[0203], claim 1 and figure 16. | 1-12 |
| A | KR 10-2023-0036707 A (SAMSUNG ELECTRONICS CO., LTD.) 15 March 2023 (2023-03-15) See paragraphs [0087]-[0113], claim 1 and figures 10-12. | 1-12 |
| A | KR 10-2023-0112482 A (KYUNGPOOK NATIONAL UNIVERSITY INDUSTRY-ACADEMIC COOPERATION FOUNDATION et al.) 27 July 2023 (2023-07-27) See paragraph [0054] and figure 12. | 1-12 |
| A | KR 10-2021-0150217 A (LG ENERGY SOLUTION, LTD.) 10 December 2021 (2021-12-10) See paragraphs [0041]-[0082] and figures 1-7. | 1-12 |
| A | KR 10-2022-0114914 A (LG ENERGY SOLUTION, LTD.) 17 August 2022 (2022-08-17) See claims 1-3 and figure 7. | 1-12 |

☐ Further documents are listed in the continuation of Box C.      ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 November 2024 | 18 November 2024 |

| Name and mailing address of the ISA/KR | Authorized officer |
|---|---|
| Korean Intellectual Property Office Government Complex-Daejeon Building 4, 189 Cheongsa-ro, Seo-gu, Daejeon 35208 | |
| Facsimile No. +82-42-481-8578 | Telephone No. |

Form PCT/ISA/210 (second sheet) (July 2022)

41

**INTERNATIONAL SEARCH REPORT**
Information on patent family members

| International application No. |
| --- |
| **PCT/KR2024/012057** |

| Patent document cited in search report | | | Publication date (day/month/year) | Patent family member(s) | | | Publication date (day/month/year) |
| --- | --- | --- | --- | --- | --- | --- | --- |
| KR | 10-2022-0094042 | A | 05 July 2022 | CN | 115398256 | A | 25 November 2022 |
| | | | | EP | 4119963 | A1 | 18 January 2023 |
| | | | | EP | 4119963 | A4 | 22 November 2023 |
| | | | | JP | 2023-515831 | A | 14 April 2023 |
| | | | | JP | 7395808 | B2 | 12 December 2023 |
| | | | | US | 12085623 | B2 | 10 September 2024 |
| | | | | US | 2023-0160970 | A1 | 25 May 2023 |
| | | | | WO | 2022-145777 | A1 | 07 July 2022 |
| KR | 10-2023-0036707 | A | 15 March 2023 | CN | 115774212 | A | 10 March 2023 |
| | | | | EP | 4148443 | A1 | 15 March 2023 |
| | | | | EP | 4148443 | B1 | 20 March 2024 |
| | | | | US | 2023-0073869 | A1 | 09 March 2023 |
| KR | 10-2023-0112482 | A | 27 July 2023 | | None | | |
| KR | 10-2021-0150217 | A | 10 December 2021 | CN | 114270204 | A | 01 April 2022 |
| | | | | CN | 114270204 | B | 03 May 2024 |
| | | | | EP | 4063883 | A1 | 28 September 2022 |
| | | | | EP | 4063883 | A4 | 09 August 2023 |
| | | | | EP | 4063883 | B1 | 09 October 2024 |
| | | | | JP | 2022-544981 | A | 24 October 2022 |
| | | | | JP | 7331326 | B2 | 23 August 2023 |
| | | | | US | 12044744 | B2 | 23 July 2024 |
| | | | | US | 2023-0333174 | A1 | 19 October 2023 |
| | | | | WO | 2021-246655 | A1 | 09 December 2021 |
| KR | 10-2022-0114914 | A | 17 August 2022 | CN | 115699404 | A | 03 February 2023 |
| | | | | EP | 4148865 | A1 | 15 March 2023 |
| | | | | EP | 4148865 | A4 | 17 April 2024 |
| | | | | JP | 2023-516953 | A | 21 April 2023 |
| | | | | US | 2023-0178818 | A1 | 08 June 2023 |
| | | | | WO | 2022-173283 | A1 | 18 August 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230115871